# EUROPEAN PATENT APPLICATION

(11) **EP 4 629 516 A1**
(43) Date of publication of application: **08.10.2025**
(21) Application number: 25164967.9
(22) Date of filing: 20.03.2025
(51) Int. Cl.: H04B 3/54, H04B 3/56

(54) **INTERFACE CIRCUIT, COMMUNICATION APPARATUS, INTERFACE SYSTEM, AND COMMUNICATION SYSTEM**

(30) Priority: 29.03.2024 JP 2024055705
(71) Applicant: MegaChips Corporation, Osaka 532-0003 (JP)
(72) Inventor: HORIKOSHI, Takeaki, Osaka-shi, Osaka, 532-0003 (JP); SATO, Yohei, Osaka-shi, Osaka, 532-0003 (JP)
(74) Representative: Winter, Brandl - Partnerschaft mbB

(57) **Abstract**

An interface circuit includes a first coupler and a first low-pass filter. The first coupler is configured to superimpose a first communication signal on a first power line transmitting a first power supply voltage of a square wave, or extract a first communication signal from a first power line transmitting a first power supply voltage of a square wave on which the first communication signal is superimposed. The first low-pass filter is inserted into the first power line and is connected to the first coupler. The first low-pass filter includes a first inductor at each of both ends of the first low-pass filter.

## Description

### BACKGROUND OF THE INVENTION

### Field of the Invention

The present disclosure relates to an interface circuit that processes a communication signal.

### Description of the Background Art

Japanese Patent Application Laid-Open No. 2007-150621 discloses technology related to power line communication.

### SUMMARY

An aspect of an interface circuit includes a first coupler and a first low-pass filter. The first coupler is configured to superimpose a first communication signal on a first power line transmitting a first power supply voltage of a square wave, or extract a first communication signal from a first power line transmitting a first power supply voltage of a square wave on which the first communication signal is superimposed. The first low-pass filter is inserted into the first power line and is connected to the first coupler. The first low-pass filter includes a first inductor at each of both ends of the first low-pass filter.

An aspect of a communication apparatus includes the interface circuit and a communication unit configured to transmit the first communication signal to the first coupler. The first coupler superimposes the first communication signal transmitted from the communication unit on the first power line.

An aspect of a communication apparatus includes the interface circuit and a communication unit configured to receive the first communication signal extracted by the first coupler from the first power line on which the first communication signal is superimposed.

An aspect of an interface system includes a first interface circuit being the interface circuit and a second interface circuit connected to the first interface circuit via the first power line. The first coupler superimposes the first communication signal on the first power line, and is connected to the first inductor of the first low-pass filter on a side of the second interface circuit. The second interface circuit includes a third coupler and a third low-pass filter. The third coupler is configured to extract the first communication signal from the first power line on which the first communication signal is superimposed. The third low-pass filter is inserted into the first power line and is connected to the third coupler. The third low-pass filter includes a third inductor at each of both ends of the third low-pass filter. The third coupler is connected to the third inductor of the third low-pass filter on a side of the first interface circuit.

An aspect of a communication system includes the interface system, a first communication unit, and a second communication unit. The first communication unit is configured to transmit the first communication signal to the first coupler. The second communication unit is configured to receive the first communication signal extracted by the third coupler from the first power line on which the first communication signal is superimposed.

An aspect of an interface circuit includes a coupler and a low-pass filter. The coupler is configured to superimpose a communication signal on a power line transmitting a DC power supply voltage, or extract a communication signal from a power line transmitting a DC power supply voltage on which the communication signal is superimposed. The low-pass filter is inserted into the power line and is electrically connected to the coupler. The low-pass filter includes an inductor at each of both ends of the low-pass filter.

### BRIEF DESCRIPTION OF THE DRAWINGS

FIG. 1 is a schematic diagram illustrating an example of a configuration of a processing system.
FIG. 2 is a schematic diagram illustrating an example of a configuration of a communication unit.
FIG 3 is a schematic diagram illustrating an example of a configuration of the processing system.
FIG 4 is a schematic diagram illustrating an example of gain frequency characteristics of low-pass filters and high-pass filters.
FIG 5 is a schematic diagram illustrating an example of gain frequency characteristics of the low-pass filters and the high-pass filters.
FIG 6 is a schematic diagram illustrating an example of a configuration of the processing system.
FIG 7 is a schematic diagram illustrating an example of a configuration of the processing system.
FIG 8 is a schematic diagram illustrating an example of a configuration of the processing system.
FIG 9 is a schematic diagram illustrating an example of a configuration of the processing system.
FIG 10 is a schematic diagram illustrating an example of a configuration of the processing system.
FIG 11 is a schematic diagram illustrating an example of a configuration of the processing system.

### DESCRIPTION OF THE PREFERRED EMBODIMENTS

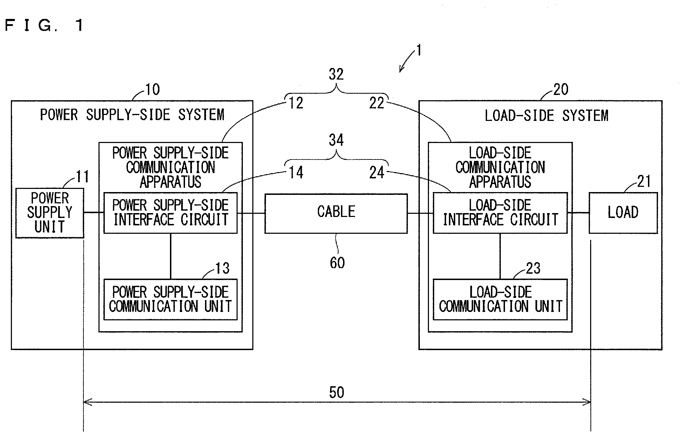

FIG. 1 is a schematic diagram illustrating an example of a processing system 1. As illustrated in FIG. 1, the processing system 1 includes a load-side system 20 including a load 21, a power supply-side system 10 that outputs a power supply voltage to be supplied to the load 21, and a cable 60 that connects the load-side system 20 and the power supply-side system 10, for example. The power supply voltage output by the power supply-side system 10 is supplied to the load-side system 20 via the cable 60. The power supply-side system 10 and the load-side system 20 can communicate with each other via the cable 60.

The power supply-side system 10 includes a power supply unit 11 that outputs the power supply voltage to be supplied to the load 21, for example. The power supply unit 11 and the load 21 are connected to each other with a power line 50 that transmits the power supply voltage output by the power supply unit 11. The power line 50 can transmit power to be supplied to the load 21. The cable 60 constitutes a part of the power line 50. The power line 50 includes a power supply-side power line that transmits the power supply voltage in the power supply-side system 10, the cable 60, and a load-side power line that transmits the power supply voltage in the load-side system 20.

The power supply-side system 10 includes a power supply-side communication apparatus 12 (also simply referred to as a communication apparatus 12), for example, in addition to the power supply unit 11. The load-side system 20 includes a load-side communication apparatus 22 (also simply referred to as a communication apparatus 22), for example, in addition to the load 21. The power supply-side communication apparatus 12 and the load-side communication apparatus 22 constitute a communication system 32.

The power supply-side communication apparatus 12 and the load-side communication apparatus 22 can perform power line communication (PLC) with each other via the power line 50, for example. A communication method between the power supply-side communication apparatus 12 and the load-side communication apparatus 22 may be HD-PLC, or may be another method. HD-PLC is a registered trademark, and is an abbreviation for "High Definition Power Line Communication".

The power supply-side communication apparatus 12 includes a power supply-side communication unit 13 (also simply referred to as a communication unit 13) and a power supply-side interface circuit 14 (also simply referred to as an interface circuit 14), for example. The power supply-side interface circuit 14 is inserted into the power line 50. The power supply voltage output by the power supply unit 11 is input to the cable 60 via the interface circuit 14.

The interface circuit 14 can perform low-pass filter processing on the power supply voltage output by the power supply unit 11, for example. The power supply voltage subjected to the low-pass filter processing in the interface circuit 14 is input to the cable 60.

The load-side communication apparatus 22 includes a load-side communication unit 23 (also simply referred to as a communication unit 23) and a load-side interface circuit 24 (also simply referred to as an interface circuit 24), for example. The load-side interface circuit 24 is inserted into the power line 50. The power supply voltage transmitted to the load-side system 20 by the cable 60 is supplied to the load 21 via the interface circuit 24.

The interface circuit 24 can perform low-pass filter processing on the input power supply voltage, for example. The interface circuit 24 supplies the power supply voltage subjected to the low-pass filter processing to the load 21.

The power supply-side communication unit 13 and the load-side communication unit 23 can communicate with each other via the power line 50, the power supply-side interface circuit 14, and the load-side interface circuit 24. The power supply-side interface circuit 14 and the load-side interface circuit 24 constitute an interface system 34. The power supply-side communication unit 13 and the load-side communication unit 23 can communicate with each other via the power line 50 and the interface system 34.

The communication unit 13 and the communication unit 23 may perform two-way communication, or may perform one-way communication. In the former case, each of the communication unit 13 and the communication unit 23 functions as a transmission and reception unit, and each of the communication apparatus 12 and the communication apparatus 22 functions as a transmission and reception apparatus. On the other hand, in the latter case, the communication unit 13 and the communication unit 23 may respectively function as a transmission unit and a reception unit, and the communication apparatus 12 and the communication apparatus 22 may respectively function as a transmission apparatus and a reception apparatus. Alternatively, the communication unit 13 and the communication unit 23 may respectively function as a reception unit and a transmission unit, and the communication apparatus 12 and the communication apparatus 22 may respectively function as a reception apparatus and a transmission apparatus.

For example, a case is considered in which the communication unit 13 transmits a communication signal and the communication unit 23 receives the communication signal from the communication unit 13. In this case, the interface circuit 14 superimposes the communication signal transmitted by the communication unit 13 on the power line 50. In other words, the interface circuit 14 superimposes the communication signal transmitted by the communication unit 13 on the power supply voltage transmitted by the power line 50. On the other hand, the interface circuit 24 extracts the communication signal from the power line 50 on which the communication signal is superimposed. The communication unit 23 receives the communication signal extracted in the interface circuit 24.

A case is considered in which the communication unit 23 transmits a communication signal and the communication unit 13 receives the communication signal from the communication unit 23. In this case, the interface circuit 24 superimposes the communication signal transmitted by the communication unit 23 on the power line 50. In other words, the interface circuit 24 superimposes the communication signal transmitted by the communication unit 23 on the power supply voltage transmitted by the power line 50. On the other hand, the interface circuit 14 extracts the communication signal from the power line 50 on which the communication signal is superimposed. The communication unit 13 receives the communication signal extracted in the interface circuit 14.

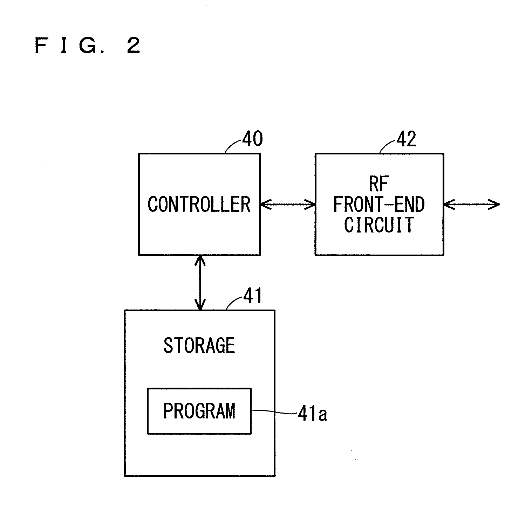

FIG. 2 is a schematic diagram illustrating an example of a configuration of the power supply-side communication unit 13 and the load-side communication unit 23. In the present example, the configuration of the power supply-side communication unit 13 and the configuration of the load-side communication unit 23 are the same as each other but may be different from each other. In the following, when the power supply-side communication unit 13 and the load-side communication unit 23 need not be distinguished from each other, each of the power supply-side communication unit 13 and the load-side communication unit 23 may be simply referred to as a communication unit. The power supply-side interface circuit 14 or the load-side interface circuit 24 connected to the communication unit may be simply referred to as an interface circuit.

As illustrated in FIG. 2, the communication unit includes a controller 40, a storage 41, and an RF front-end circuit 42, for example. RF is an abbreviation for "Radio Frequency". It can also be said that the communication unit is a communication circuit, for example.

The controller 40 can comprehensively manage operation of the communication unit by controlling other constituent elements of the communication unit. It can also be said that the controller 40 is a control circuit, for example. The controller 40 includes at least one processor, for example. The at least one processor may include a central processing unit (CPU), for example.

The storage 41 may include a non-transitory recording medium that can be read by the CPU of the controller 40, such as a read only memory (ROM) and a random access memory (RAM). The storage 41 stores a program 41a for controlling the communication unit and so on, for example. Various functions of the controller 40 are implemented by the CPU of the controller 40 executing the program 41a in the storage 41, for example.

When the communication unit transmits a communication signal to the interface circuit, the controller 40 generates the communication signal (also referred to as a transmission signal) and inputs the communication signal to the RF front-end circuit 42. The controller 40 generates the communication signal by performing digital modulation processing using information to be transmitted, for example. It can also be said that the communication signal is a modulated signal. A modulation scheme used by the controller 40 may be FSK, may be QPSK, or may be another method, for example. The controller 40 may use MSK, which is a type of FSK. FSK is an abbreviation for "Frequency Shift Keying", MSK is an abbreviation for "Minimum Shift Keying", and QPSK is an abbreviation for "Quadrature Phase Shift Keying".

When the communication unit transmits the communication signal to the interface circuit, the RF front-end circuit 42 converts the communication signal in digital form input from the controller 40 into analog form, for example. Then, the RF front-end circuit 42 transmits the communication signal in analog form to the interface circuit. In this case, the RF front-end circuit 42 may amplify the communication signal in analog form and transmit the amplified communication signal to the interface circuit. The RF front-end circuit 42 may convert the communication signal in single-ended form generated in the controller 40 into differential form to transmit the communication signal, or may transmit the communication signal generated in the controller 40 as it is in single-ended form. Note that the controller 40 may convert the generated communication signal in digital form into analog form, and input the communication signal in analog form to the RF front-end circuit 42.

When the communication unit receives a communication signal, the RF front-end circuit 42 receives the communication signal extracted from the power line 50 by the interface circuit, and performs, for example, attenuation processing and filter processing on the received communication signal. Then, the RF front-end circuit 42 converts the communication signal subjected to the attenuation processing and the filter processing from analog form into digital form, and inputs the communication signal in digital form to the controller 40. When the RF front-end circuit 42 receives a communication signal in differential form, the RF front-end circuit 42 may convert the communication signal from differential form into single-ended form and input the communication signal to the controller 40. The controller 40 performs demodulation processing or the like on the communication signal (also referred to as a received signal) input from the RF front-end circuit 42, and acquires information included in the communication signal from the communication signal. Note that the RF front-end circuit 42 may input the communication signal in analog form to the controller 40, and the controller 40 may convert the input communication signal from analog form into digital form.

The configuration of the communication unit is not limited to the above example. For example, the controller 40 may include a plurality of CPUs. The controller 40 may include at least one digital signal processor (DSP). All of the functions of the controller 40 or a part of the functions of the controller 40 may be implemented by a hardware circuit that does not require software to implement its functions. The storage 41 may include a computer-readable non-transitory recording medium other than the ROM and the RAM. The communication unit may include a microcomputer including the controller 40 and the storage 41.

The load 21 included in the load-side system 20 may be of any type. For example, the load 21 may be an actuator. In this case, the load 21 may be a motor, may be a hydraulic actuator, may be a pneumatic actuator, or may be an electric actuator not using a motor.

### <Specific Example of Processing System>

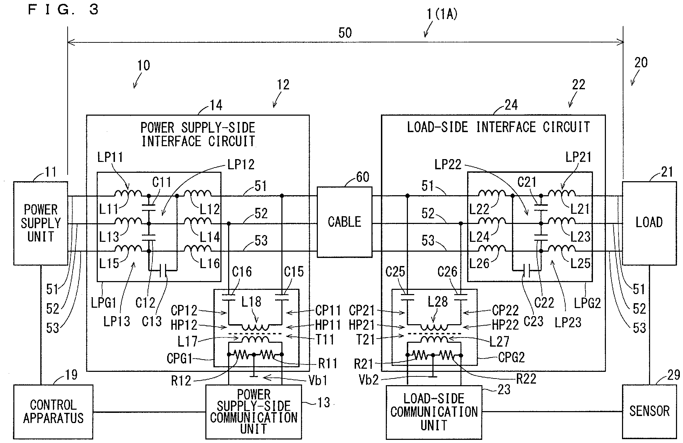

A specific example of the processing system 1 will be described below. FIG. 3 is a schematic diagram illustrating an example of the processing system 1 when the load 21 is a brushless DC motor or an AC servomotor driven with three-phase power. DC is an abbreviation for "Direct Current". AC is an abbreviation for "Alternating Current". In the following, when the brushless DC motor and the AC servomotor need not be particularly distinguished from each other, each of the brushless DC motor and the AC servomotor is simply referred to as a motor.

The motor is also referred to as a three-phase motor, and includes three coils. A method of connecting the three coils may be star connection, or may be delta connection. The motor as the load 21 may be used to drive a robot, may be used to drive a belt conveyor, or may be used for another purpose. In the following, the term "motor" by itself means the motor as the load 21.

In the processing system 1 (also referred to as a processing system 1A) illustrated in FIG. 3, the power supply unit 11 outputs the power supply voltage of the motor. The power line 50 transmits the power supply voltage output from the power supply unit 11 to the motor. The power line 50 is a three-phase power line, and includes a U-phase power line 51, a V-phase power line 52, and a W-phase power line 53. Each of the U-phase power line 51, the V-phase power line 52, and the W-phase power line 53 extends from the power supply unit 11 to the motor. The cable 60 connecting the power supply-side system 10 and the load-side system 20 constitutes a part of each of the U-phase power line 51, the V-phase power line 52, and the W-phase power line 53.

The power supply unit 11 includes an inverter circuit, for example. It can also be said that the power supply unit 11 is a power supply circuit, for example. The inverter circuit generates and outputs a U-phase voltage, a V-phase voltage, and a W-phase voltage. The U-phase power line 51 transmits the U-phase voltage output by the power supply unit 11 to the motor. The V-phase power line 52 transmits the V-phase voltage output by the power supply unit 11 to the motor. The W-phase power line 53 transmits the W-phase voltage output by the power supply unit 11 to the motor. Each of the U-phase voltage, the V-phase voltage, and the W-phase voltage is a square wave voltage, and can be said to be a power supply voltage of a square wave of the motor. The square wave voltage includes a fundamental wave component and a harmonic component. When the U-phase voltage, the V-phase voltage, and the W-phase voltage of a square wave are supplied to the motor, the brushless motor is subjected to PWM control. PWM is an abbreviation for "Pulse Width Modulation". The maximum value of the U-phase voltage, the V-phase voltage, and the W-phase voltage is several hundred volts, for example.

The power supply-side interface circuit 14 is inserted into the U-phase power line 51, the V-phase power line 52, and the W-phase power line 53. The interface circuit 14 can perform the low-pass filter processing on the U-phase voltage, the V-phase voltage, and the W-phase voltage output by the power supply unit 11. The U-phase voltage, the V-phase voltage, and the W-phase voltage subjected to the low-pass filter processing in the interface circuit 14 are input to the cable 60.

The interface circuit 14 performs, on the U-phase voltage, the low-pass filter processing of allowing the fundamental wave component of the U-phase voltage to pass and attenuating the harmonic component of the U-phase voltage. The interface circuit 14 performs, on the V-phase voltage, the low-pass filter processing of allowing the fundamental wave component of the V-phase voltage to pass and attenuating the harmonic component of the V-phase voltage. The interface circuit 14 performs, on the W-phase voltage, the low-pass filter processing of allowing the fundamental wave component of the W-phase voltage to pass and attenuating the harmonic component of the W-phase voltage. To the cable 60, the U-phase voltage including the fundamental wave component and the harmonic component attenuated in the interface circuit 14, the V-phase voltage including the fundamental wave component and the harmonic component attenuated in the interface circuit 14, and the W-phase voltage including the fundamental wave component and the harmonic component attenuated in the interface circuit 14 are input. Frequencies of the fundamental wave components of the U-phase voltage, the V-phase voltage, and the W-phase voltage are the same as each other, and are several kHz, for example. Note that the frequencies of the fundamental wave components of the U-phase voltage, the V-phase voltage, and the W-phase voltage are not limited to this.

The load-side interface circuit 24 is inserted into the U-phase power line 51, the V-phase power line 52, and the W-phase power line 53. The interface circuit 24 can perform the low-pass filter processing on the U-phase voltage, the V-phase voltage, and the W-phase voltage transmitted to the load-side system 20 by the cable 60. The U-phase voltage, the V-phase voltage, and the W-phase voltage subjected to the low-pass filter processing in the interface circuit 24 are supplied to the load 21, i.e., the motor.

The interface circuit 24 performs, on the U-phase voltage, the low-pass filter processing of allowing the fundamental wave component of the U-phase voltage to pass and attenuating the harmonic component of the U-phase voltage. The interface circuit 24 performs, on the V-phase voltage, the low-pass filter processing of allowing the fundamental wave component of the V-phase voltage to pass and attenuating the harmonic component of the V-phase voltage. The interface circuit 24 performs, on the W-phase voltage, the low-pass filter processing of allowing the fundamental wave component of the W-phase voltage to pass and attenuating the harmonic component of the W-phase voltage. To the motor, the U-phase voltage including the fundamental wave component and the harmonic component attenuated in the interface circuit 24, the V-phase voltage including the fundamental wave component and the harmonic component attenuated in the interface circuit 24, and the W-phase voltage including the fundamental wave component and the harmonic component attenuated in the interface circuit 24 are input.

As described above, in the processing system 1A, the U-phase voltage, the V-phase voltage, and the W-phase voltage output by the power supply unit 11 are subjected to the low-pass filter processing in the interface circuit 14 and the interface circuit 24, and are then supplied to the motor. Accordingly, high-frequency noise included in the power supply voltage of the motor is reduced.

In the processing system 1A, the power supply-side communication apparatus 12 and the load-side communication apparatus 22 can perform two-way communication, for example. The power supply-side communication apparatus 12 and the load-side communication apparatus 22 can perform differential communication, for example. The power supply-side communication unit 13 can transmit a communication signal in differential form (also referred to as a differential signal), and the load-side communication unit 23 can receive the differential signal transmitted by the power supply-side communication unit 13. The load-side communication unit 23 can transmit a differential signal, and the power supply-side communication unit 13 can receive the differential signal transmitted by the load-side communication unit 23. The maximum voltage of the differential signal is several volts, for example.

In the following, the differential signal transmitted by the communication unit 13 may be referred to as a power supply-side differential signal, and the differential signal transmitted by the communication unit 23 may be referred to as a load-side differential signal. Each of two communication signals as a pair constituting the power supply-side differential signal may be referred to as a power supply-side communication signal. Each of two communication signals as a pair constituting the load-side differential signal may be referred to as a load-side communication signal.

The power supply-side interface circuit 14 superimposes the power supply-side differential signal transmitted by the communication unit 13 on two power lines out of the U-phase power line 51, the V-phase power line 52, and the W-phase power line 53. Specifically, the power supply-side interface circuit 14 superimposes a pair of power supply-side communication signals transmitted by the communication unit 13 respectively on two power lines out of the U-phase power line 51, the V-phase power line 52, and the W-phase power line 53.

In the example of FIG. 3, the power supply-side differential signal is superimposed on the U-phase power line 51 and the V-phase power line 52. The interface circuit 14 superimposes one power supply-side communication signal on the U-phase voltage (i.e., the square wave voltage) transmitted by the U-phase power line 51, and superimposes the other power supply-side communication signal on the V-phase voltage (i.e., the square wave voltage) transmitted by the V-phase power line 52. The U-phase power line 51 transmits the power supply-side communication signal superimposed thereon to the load-side interface circuit 24, and the V-phase power line 52 transmits the power supply-side communication signal superimposed thereon to the load-side interface circuit 24. Note that the power supply-side differential signal may be superimposed on the U-phase power line 51 and the W-phase power line 53, or may be superimposed on the V-phase power line 52 and the W-phase power line 53.

The load-side interface circuit 24 superimposes the load-side differential signal transmitted by the communication unit 23 on two power lines out of the U-phase power line 51, the V-phase power line 52, and the W-phase power line 53. In the example of FIG. 3, the load-side differential signal is superimposed on the U-phase power line 51 and the V-phase power line 52. The interface circuit 24 superimposes one load-side communication signal on the U-phase power line 51, and superimposes the other load-side communication signal on the V-phase power line 52. The U-phase power line 51 transmits the load-side communication signal superimposed thereon to the interface circuit 14, and the V-phase power line 52 transmits the load-side communication signal superimposed thereon to the interface circuit 14. Note that the load-side differential signal may be superimposed on the U-phase power line 51 and the W-phase power line 53, or may be superimposed on the V-phase power line 52 and the W-phase power line 53.

The power supply-side interface circuit 14 extracts the load-side differential signal from the U-phase power line 51 and the V-phase power line 52 on which the load-side differential signal is superimposed, and outputs the load-side differential signal to the power supply-side communication unit 13. The communication unit 13 receives the load-side differential signal extracted in the interface circuit 14. The interface circuit 14 extracts one load-side communication signal from the U-phase power line 51 on which the one load-side communication signal is superimposed, and outputs the one load-side communication signal to the communication unit 13. The interface circuit 14 extracts the other load-side communication signal from the V-phase power line 52 on which the other load-side communication signal is superimposed, and outputs the other load-side communication signal to the communication unit 13.

The load-side interface circuit 24 extracts the power supply-side differential signal from the U-phase power line 51 and the V-phase power line 52 on which the power supply-side differential signal is superimposed, and outputs the power supply-side differential signal to the load-side communication unit 23. The communication unit 23 receives the power supply-side differential signal extracted in the interface circuit 24. The interface circuit 24 extracts one power supply-side communication signal from the U-phase power line 51 on which the one power supply-side communication signal is superimposed, and outputs the one power supply-side communication signal to the communication unit 23. The interface circuit 24 extracts the other power supply-side communication signal from the V-phase power line 52 on which the other power supply-side communication signal is superimposed, and outputs the other power supply-side communication signal to the communication unit 23.

In the processing system 1, as illustrated in FIG. 3, the load-side system 20 may be provided with a sensor 29 that detects a state of the load 21, and the power supply-side system 10 may be provided with a control apparatus 19 that controls the power supply unit 11 based on detection results in the sensor 29.

When the load 21 is a brushless DC motor, the sensor 29 includes a Hall sensor that detects a rotational position of the brushless DC motor, for example. The sensor 29 outputs sensor information indicating detection results of the Hall sensor to the load-side communication unit 23. The sensor 29 may include the Hall sensor and an encoder that detects rotational speed of the brushless DC motor. In this case, the sensor 29 outputs the detection results of the Hall sensor and sensor information indicating detection results of the encoder to the load-side communication unit 23. When the load 21 is an AC servomotor, the sensor 29 includes an encoder that detects rotational speed of the AC servomotor, for example. The sensor 29 outputs sensor information indicating detection results of the encoder to the load-side communication unit 23.

The load-side communication unit 23 transmits the load-side differential signal including the sensor information from the sensor 29. The power supply-side communication unit 13 receives the load-side differential signal including the sensor information. In the power supply-side communication unit 13, the controller 40 acquires the sensor information included in the load-side differential signal received by the RF front-end circuit 42. The sensor information acquired in the controller 40 is input to the control apparatus 19.

The control apparatus 19 controls the inverter circuit included in the power supply unit 11, based on the sensor information from the power supply-side communication unit 13. The control apparatus 19 controls the inverter circuit of the power supply unit 11 based on the sensor information, so that the rotational position or the rotational speed of the motor reaches a target value, for example. The control apparatus 19 can control rotation of the motor via the power supply unit 11.

The sensor 29 outputs the sensor information in response to an output request from the control apparatus 19, for example. The control apparatus 19 transmits output request information indicating the output request for the sensor information to the power supply-side communication unit 13. The power supply-side communication unit 13 transmits the power supply-side differential signal including the output request information from the control apparatus 19. The load-side communication unit 23 receives the power supply-side differential signal including the output request information. In the load-side communication unit 23, the controller 40 acquires the output request information included in the power supply-side differential signal received by the RF front-end circuit 42. The load-side communication unit 23 outputs the acquired output request information to the sensor 29. The sensor 29 outputs the sensor information in response to reception of the output request information. The sensor information output from the sensor 29 is input to the control apparatus 19.

It can also be said that the processing system 1A illustrated in FIG. 3 is a servo system that controls the motor, for example. It can also be said that the power supply-side system 10 is a servo amplifier, for example, and it can also be said that the load-side system 20 is a servomotor or a servo actuator, for example.

### <Configuration Example of Power Supply-Side Interface Circuit>

The power supply-side interface circuit 14 includes a low-pass filter unit LPG1 including a plurality of low-pass filters LP11, LP12, and LP13 and a coupler unit CPG1 including a plurality of couplers CP11 and CP12, for example.

The low-pass filter unit LPG1 is inserted into the U-phase power line 51, the V-phase power line 52, and the W-phase power line 53. The low-pass filter unit LPG1 performs low-pass filter processing on the U-phase voltage, the V-phase voltage, and the W-phase voltage output from the power supply unit 11.

The coupler unit CPG1 is connected to an end of the low-pass filter unit LPG1 on the interface circuit 24 side. The coupler unit CPG1 superimposes the power supply-side differential signal transmitted by the communication unit 13 on the U-phase power line 51 and the V-phase power line 52 on the interface circuit 24 side (i.e., the cable 60 side) with respect to the low-pass filter unit LPG1. The coupler unit CPG1 superimposes a pair of power supply-side communication signals respectively on the U-phase voltage and the V-phase voltage subjected to the low-pass filter processing in the low-pass filter unit LPG1. The coupler unit CPG1 extracts the load-side differential signal from the U-phase power line 51 and the V-phase power line 52 on which the load-side differential signal is superimposed, and outputs the load-side differential signal to the communication unit 13.

### <Configuration Example of Coupler Unit>

The coupler unit CPG1 includes capacitors C15 and C16, an isolation transformer T11, and resistors R11 and R12, for example. The isolation transformer T11 includes a primary-side coil L17 and a secondary-side coil L18. The primary-side coil L17 is connected to the communication unit 13. One end of the resistor R11 is connected to one end of the primary-side coil L17. One end of the resistor R12 is connected to the other end of the primary-side coil L17. The other end of the resistor R11 is connected to the other end of the resistor R12. A bias voltage Vb1 is applied to the other end of the resistor R11 and the other end of the resistor R12. The bias voltage Vb1 is applied to the one end of the primary-side coil L17 via the resistor R11. The bias voltage Vb1 is applied to the other end of the primary-side coil L17 via the resistor R12. Both ends of the secondary-side coil L18 are respectively connected to one end of the capacitor C15 and one end of the capacitor C16. The other ends of the capacitors C15 and C16 are respectively connected to the U-phase power line 51 and the V-phase power line 52.

To the primary-side coil L17, the power supply-side differential signal transmitted by the communication unit 13 is input. One power supply-side communication signal of the power supply-side differential signal output from the secondary-side coil L18 is input to the one end of the capacitor C15. The other power supply-side communication signal of the power supply-side differential signal output from the secondary-side coil L18 is input to the one end of the capacitor C16.

When the load-side differential signal is superimposed on the U-phase power line 51 and the V-phase power line 52, one load-side communication signal superimposed on the U-phase power line 51 is input to the other end of the capacitor C15, and the other load-side communication signal superimposed on the V-phase power line 52 is input to the other end of the capacitor C16.

The capacitor C15, the isolation transformer T11, and the resistor R11 constitute the coupler CP11 that superimposes the one power supply-side communication signal transmitted by the communication unit 13 on the U-phase power line 51. The one power supply-side communication signal of the power supply-side differential signal output from the secondary-side coil L18 is superimposed on the U-phase power line 51 via the capacitor C15.

The coupler CP11 can extract the one load-side communication signal from the U-phase power line 51 on which the one load-side communication signal of the load-side differential signal is superimposed. The one load-side communication signal extracted from the U-phase power line 51 via the capacitor C15 is input to the communication unit 13 via the isolation transformer T11.

The capacitor C16, the isolation transformer T11, and the resistor R12 constitute the coupler CP12 that superimposes the other power supply-side communication signal transmitted by the communication unit 13 on the V-phase power line 52. The other power supply-side communication signal of the power supply-side differential signal output from the secondary-side coil L18 is superimposed on the V-phase power line 52 via the capacitor C16.

The coupler CP12 can extract the other load-side communication signal from the V-phase power line 52 on which the other load-side communication signal of the load-side differential signal is superimposed. The other load-side communication signal extracted from the V-phase power line 52 via the capacitor C16 is input to the communication unit 13 via the isolation transformer T11.

The coupler CP11 constitutes a high-pass filter HP11. In other words, the capacitor C15, the isolation transformer T11, and the resistor R11 constitute the high-pass filter HP11. The order of the high-pass filter HP11 is even order, for example. Specifically, the order of the high-pass filter HP11 is second order. The high-pass filter HP11 performs high-pass filter processing on one power supply-side communication signal transmitted by the communication unit 13. On the U-phase power line 51, the one power supply-side communication signal subjected to the high-pass filter processing in the high-pass filter HP11 is superimposed. The high-pass filter HP11 performs high-pass filter processing on one load-side communication signal extracted from the U-phase power line 51. The one load-side communication signal subjected to the high-pass filter processing in the high-pass filter HP11 is received in the communication unit 13.

The coupler CP12 constitutes a high-pass filter HP12. In other words, the capacitor C16, the isolation transformer T11, and the resistor R12 constitute the high-pass filter HP12. The order of the high-pass filter HP12 is even order, for example. Specifically, the order of the high-pass filter HP12 is second order. The high-pass filter HP12 performs high-pass filter processing on the other power supply-side communication signal transmitted by the communication unit 13. On the V-phase power line 52, the other power supply-side communication signal subjected to the high-pass filter processing in the high-pass filter HP12 is superimposed. The high-pass filter HP12 performs high-pass filter processing on the other load-side communication signal extracted from the V-phase power line 52. The other load-side communication signal subjected to the high-pass filter processing in the high-pass filter HP12 is received in the communication unit 13.

### <Configuration Example of Low-Pass Filter Unit>

The low-pass filter unit LPG1 includes inductors L11, L12, L13, L14, L15, and L16 and capacitors C11, C12, and C13, for example. The inductors L11 and L12 are connected to each other in series, and are inserted into the U-phase power line 51. One end of the inductor L11 is connected to the power supply unit 11, and the other end of the inductor L11 is connected to one end of the inductor L12. The other end of the inductor L12 is connected to the other end of the capacitor C15 of the coupler CP11 and the cable 60. The U-phase voltage output by the power supply unit 11 is input to the one end of the inductor L11.

The inductors L13 and L14 are connected to each other in series, and are inserted into the V-phase power line 52. One end of the inductor L13 is connected to the power supply unit 11, and the other end of the inductor L13 is connected to one end of the inductor L14. The other end of the inductor L14 is connected to the other end of the capacitor C16 of the coupler CP12 and the cable 60. The V-phase voltage output by the power supply unit 11 is input to the one end of the inductor L13.

The inductors L15 and L16 are connected to each other in series, and are inserted into the W-phase power line 53. One end of the inductor L15 is connected to the power supply unit 11, and the other end of the inductor L15 is connected to one end of the inductor L16. The other end of the inductor L16 is connected to the cable 60. The W-phase voltage output by the power supply unit 11 is input to the one end of the inductor L15.

One end of the capacitor C11 is connected to the other end of the inductor L11 and the one end of the inductor L12. The other end of the capacitor C11 is connected to the other end of the inductor L13 and the one end of the inductor L14. One end of the capacitor C12 is connected to the other end of the inductor L13 and the one end of the inductor L14. The other end of the capacitor C12 is connected to the other end of the inductor L15 and the one end of the inductor L16. One end of the capacitor C13 is connected to the other end of the inductor L15 and the one end of the inductor L16. The other end of the capacitor C13 is connected to the other end of the inductor L11 and the one end of the inductor L12.

In the low-pass filter unit LPG1, the inductors L11 and L12 and the capacitors C11, C12, and C13 constitute the low-pass filter LP11 that performs the low-pass filter processing on the U-phase voltage transmitted by the U-phase power line 51 (i.e., the U-phase voltage output by the power supply unit 11). The U-phase voltage subjected to the low-pass filter processing in the low-pass filter LP11 is transmitted to the load-side system 20 via the cable 60. The U-phase voltage subjected to the low-pass filter processing in the low-pass filter LP11 is not a sine wave voltage but is a square wave voltage including a fundamental wave component and a harmonic component (specifically, a harmonic component attenuated further than the time before being subjected to the low-pass filter processing). The order of the low-pass filter LP11 is odd order, for example. Specifically, the order of the low-pass filter LP11 is third order.

In the low-pass filter unit LPG1, the inductors L13 and L14 and the capacitors C11, C12, and C13 constitute the low-pass filter LP12 that performs the low-pass filter processing on the V-phase voltage transmitted by the V-phase power line 52 (i.e., the V-phase voltage output by the power supply unit 11). The V-phase voltage subjected to the low-pass filter processing in the low-pass filter LP12 is transmitted to the load-side system 20 via the cable 60. The V-phase voltage subjected to the low-pass filter processing in the low-pass filter LP12 is not a sine wave voltage but is a square wave voltage including a fundamental wave component and a harmonic component. The order of the low-pass filter LP12 is odd order, for example. Specifically, the order of the low-pass filter LP12 is third order.

In the low-pass filter unit LPG1, the inductors L15 and L16 and the capacitors C11, C12, and C13 constitute the low-pass filter LP13 that performs the low-pass filter processing on the W-phase voltage transmitted by the W-phase power line 53 (i.e., the W-phase voltage output by the power supply unit 11). The W-phase voltage subjected to the low-pass filter processing in the low-pass filter LP13 is transmitted to the load-side system 20 via the cable 60. The W-phase voltage subjected to the low-pass filter processing in the low-pass filter LP13 is not a sine wave voltage but is a square wave voltage including a fundamental wave component and a harmonic component. The order of the low-pass filter LP13 is odd order, for example. Specifically, the order of the low-pass filter LP13 is third order.

As described above, in the interface circuit 14, the low-pass filters LP11, LP12, and LP13 perform the low-pass filter processing on the U-phase voltage, the V-phase voltage, and the W-phase voltage, and thus the harmonic components included in the U-phase voltage, the V-phase voltage, and the W-phase voltage are attenuated. Accordingly, high-frequency noise due to the U-phase voltage, the V-phase voltage, and the W-phase voltage is less easily transmitted to the power supply-side communication unit 13, and thus communication quality between the power supply-side communication unit 13 and the load-side communication unit 23 (which is also simply referred to as the communication quality) can be enhanced. The high-frequency noise due to the U-phase voltage, the V-phase voltage, and the W-phase voltage is less easily transmitted to the load-side system 20. For example, the high-frequency noise is less easily transmitted to the load 21. The high-frequency noise due to the U-phase voltage, the V-phase voltage, and the W-phase voltage is less easily transmitted to the load-side communication unit 23, and thus the communication quality can be enhanced. It can also be said that the high-frequency noise due to the U-phase voltage, the V-phase voltage, and the W-phase voltage is high-frequency noise generated in the power supply unit 11.

Even if high-frequency noise is generated in at least one of the power supply-side communication unit 13 and the load-side system 20, the high-frequency noise is less easily transmitted to the power supply unit 11 owing to the low-pass filters LP11, LP12, and LP13.

In the present example, the couplers CP11 and CP12 of the coupler unit CPG1 function as the high-pass filters HP11 and HP12, and thus even if low-frequency noise is generated in the power supply-side communication unit 13, the low-frequency noise is less easily superimposed on the U-phase power line 51 and the V-phase power line 52. Accordingly, the low-frequency noise is less easily transmitted to the power supply unit 11 and the load-side system 20. With the low-frequency noise being less easily transmitted to the load-side communication unit 23 of the load-side system 20, the communication quality can be enhanced. Even if low-frequency noise is generated in at least one of the power supply unit 11 and the load-side system 20, the low-frequency noise is less easily transmitted to the power supply-side communication unit 13, and thus the communication quality can be enhanced.

In the present example, the low-pass filter LP11 inserted into the U-phase power line 51 includes the inductors L11 and L12 at its both ends. The inductor L12 on the coupler CP11 side functions as an impedance increaser for the power supply-side communication signal to be superimposed on the U-phase power line 51 by the coupler CP11, and thus the power supply-side communication signal superimposed on the U-phase power line 51 is less easily transmitted toward the power supply unit 11. Accordingly, the signal level of the power supply-side communication signal input to the load-side communication unit 23 via the U-phase power line 51 is less easily reduced, and thus the communication quality can be enhanced. An impedance increaser is also referred to as an impedance upper. The inductor L12 functions as an impedance increaser for the load-side communication signal to be superimposed on the U-phase power line 51 by the coupler CP21, and thus the load-side communication signal superimposed on the U-phase power line 51 is less easily transmitted toward the power supply unit 11. Accordingly, the signal level of the load-side communication signal input to the power supply-side communication unit 13 via the U-phase power line 51 is less easily reduced, and thus the communication quality can be enhanced. On the other hand, the inductor L11 is present on the power supply unit 11 side, and thus even if output impedance of the power supply unit 11 (i.e., impedance seen from the side of the low-pass filter LP11 of the power supply unit 11) is low, the low-pass filter LP11 can appropriately attenuate the harmonic component included in the U-phase voltage output from the power supply unit 11.

In the present example, the low-pass filter LP12 inserted into the V-phase power line 52 includes the inductors L13 and L14 at its both ends. The inductor L14 on the coupler CP12 side functions as an impedance increaser for the power supply-side communication signal to be superimposed on the V-phase power line 52 by the coupler CP12, and thus the power supply-side communication signal superimposed on the V-phase power line 52 is less easily transmitted toward the power supply unit 11. Accordingly, the signal level of the power supply-side communication signal input to the load-side communication unit 23 via the V-phase power line 52 is less easily reduced, and thus the communication quality can be enhanced. The inductor L14 functions as an impedance increaser for the load-side communication signal to be superimposed on the V-phase power line 52 by the coupler CP22, and thus the load-side communication signal superimposed on the V-phase power line 52 is less easily transmitted toward the power supply unit 11. Accordingly, the signal level of the load-side communication signal input to the power supply-side communication unit 13 via the V-phase power line 52 is less easily reduced, and thus the communication quality can be enhanced. On the other hand, the inductor L13 is present on the power supply unit 11 side, and thus even if output impedance of the power supply unit 11 is low, the low-pass filter LP12 can appropriately attenuate the harmonic component included in the V-phase voltage output from the power supply unit 11.

### <Configuration Example of Load-Side Interface Circuit>

The load-side interface circuit 24 includes a configuration similar to that of the power supply-side interface circuit 14, for example. The interface circuit 24 includes a low-pass filter unit LPG2 including a plurality of low-pass filters LP21, LP22, and LP23 and a coupler unit CPG2 including a plurality of couplers CP21 and CP22, for example.

The low-pass filter unit LPG2 is inserted into the U-phase power line 51, the V-phase power line 52, and the W-phase power line 53. The low-pass filter unit LPG2 performs low-pass filter processing on the U-phase voltage, the V-phase voltage, and the W-phase voltage transmitted to the load-side system 20 by the cable 60.

The coupler unit CPG2 is connected to an end of the low-pass filter unit LPG2 on the interface circuit 14 side. The coupler unit CPG2 superimposes the load-side differential signal transmitted by the communication unit 23 on the U-phase power line 51 and the V-phase power line 52 on the interface circuit 24 side (i.e., the cable 60 side) with respect to the low-pass filter unit LPG2. The coupler unit CPG2 extracts the power supply-side differential signal from the U-phase power line 51 and the V-phase power line 52 on which the power supply-side differential signal is superimposed, and outputs the power supply-side differential signal to the communication unit 23.

### <Configuration Example of Coupler Unit>

The coupler unit CPG2 includes capacitors C25 and C26, an isolation transformer T21, and resistors R21 and R22, for example. The isolation transformer T21 includes a primary-side coil L27 and a secondary-side coil L28. The primary-side coil L27 is connected to the communication unit 23. One end of the resistor R21 is connected to one end of the primary-side coil L27. One end of the resistor R22 is connected to the other end of the primary-side coil L27. The other end of the resistor R21 is connected to the other end of the resistor R22. A bias voltage Vb2 is applied to the other end of the resistor R21 and the other end of the resistor R22. The bias voltage Vb2 is applied to the one end of the primary-side coil L27 via the resistor R21. The bias voltage Vb2 is applied to the other end of the primary-side coil L27 via the resistor R22. Both ends of the secondary-side coil L28 are respectively connected to one end of the capacitor C25 and one end of the capacitor C26. The other ends of the capacitors C25 and C26 are respectively connected to the U-phase power line 51 and the V-phase power line 52.

To the primary-side coil L27, the load-side differential signal transmitted by the communication unit 23 is input. One load-side communication signal of the load-side differential signal output from the secondary-side coil L28 is input to the one end of the capacitor C25. The other load-side communication signal of the load-side differential signal output from the secondary-side coil L28 is input to the one end of the capacitor C26.

When the power supply-side differential signal is superimposed on the U-phase power line 51 and the V-phase power line 52, one power supply-side communication signal superimposed on the U-phase power line 51 is input to the other end of the capacitor C25, and the other power supply-side communication signal superimposed on the V-phase power line 52 is input to the other end of the capacitor C26.

The capacitor C25, the isolation transformer T21, and the resistor R21 constitute the coupler CP21 that superimposes the one load-side communication signal transmitted by the communication unit 23 on the U-phase power line 51. The one load-side communication signal of the load-side differential signal output from the secondary-side coil L28 is superimposed on the U-phase power line 51 via the capacitor C25.

The coupler CP21 can extract the one power supply-side communication signal from the U-phase power line 51 on which the one power supply-side communication signal of the power supply-side differential signal is superimposed. The one power supply-side communication signal extracted from the U-phase power line 51 via the capacitor C25 is input to the communication unit 23 via the isolation transformer T21.

The capacitor C26, the isolation transformer T21, and the resistor R22 constitute the coupler CP22 that superimposes the other load-side communication signal transmitted by the communication unit 23 on the V-phase power line 52. The other load-side communication signal of the load-side differential signal output from the secondary-side coil L28 is superimposed on the V-phase power line 52 via the capacitor C26.

The coupler CP22 can extract the other power supply-side communication signal from the V-phase power line 52 on which the other power supply-side communication signal of the power supply-side differential signal is superimposed. The other power supply-side communication signal extracted from the V-phase power line 52 via the capacitor C26 is input to the communication unit 23 via the isolation transformer T21.

The coupler CP21 constitutes a high-pass filter HP21. The order of the high-pass filter HP21 is even order, for example. Specifically, the order of the high-pass filter HP21 is second order. The high-pass filter HP21 performs high-pass filter processing on one load-side communication signal transmitted by the communication unit 23. On the U-phase power line 51, the one load-side communication signal subjected to the high-pass filter processing in the high-pass filter HP21 is superimposed. The high-pass filter HP21 performs high-pass filter processing on one power supply-side communication signal extracted from the U-phase power line 51. The one power supply-side communication signal subjected to the high-pass filter processing in the high-pass filter HP21 is received in the communication unit 23.

The coupler CP22 constitutes a high-pass filter HP22. The order of the high-pass filter HP22 is even order, for example. Specifically, the order of the high-pass filter HP22 is second order. The high-pass filter HP22 performs high-pass filter processing on the other load-side communication signal transmitted by the communication unit 23. On the V-phase power line 52, the other load-side communication signal subjected to the high-pass filter processing in the high-pass filter HP22 is superimposed. The high-pass filter HP22 performs high-pass filter processing on the other power supply-side communication signal extracted from the V-phase power line 52. The other power supply-side communication signal subjected to the high-pass filter processing in the high-pass filter HP22 is received in the communication unit 23.

### <Configuration Example of Low-Pass Filter Unit>

The low-pass filter unit LPG2 includes inductors L21, L22, L23, L24, L25, and L26 and capacitors C21, C22, and C23, for example. The inductors L21 and L22 are connected to each other in series, and are inserted into the U-phase power line 51. One end of the inductor L21 is connected to the motor, and the other end of the inductor L21 is connected to one end of the inductor L22. The other end of the inductor L22 is connected to the other end of the capacitor C25 of the coupler CP21 and the cable 60. The U-phase voltage transmitted to the load-side system 20 by the U-phase power line 51 is input to the other end of the inductor L22.

The inductors L23 and L24 are connected to each other in series, and are inserted into the V-phase power line 52. One end of the inductor L23 is connected to the motor, and the other end of the inductor L23 is connected to one end of the inductor L24. The other end of the inductor L24 is connected to the other end of the capacitor C26 of the coupler CP22 and the cable 60. The V-phase voltage transmitted to the load-side system 20 by the V-phase power line 52 is input to the other end of the inductor L24.

The inductors L25 and L26 are connected to each other in series, and are inserted into the W-phase power line 53. One end of the inductor L25 is connected to the motor, and the other end of the inductor L25 is connected to one end of the inductor L26. The other end of the inductor L26 is connected to the cable 60. The W-phase voltage transmitted to the load-side system 20 by the W-phase power line 53 is input to the other end of the inductor L26.

One end of the capacitor C21 is connected to the other end of the inductor L21 and the one end of the inductor L22. The other end of the capacitor C21 is connected to the other end of the inductor L23 and the one end of the inductor L24. One end of the capacitor C22 is connected to the other end of the inductor L23 and the one end of the inductor L24. The other end of the capacitor C22 is connected to the other end of the inductor L25 and the one end of the inductor L26. One end of the capacitor C23 is connected to the other end of the inductor L25 and the one end of the inductor L26. The other end of the capacitor C23 is connected to the other end of the inductor L21 and the one end of the inductor L22.

In the low-pass filter unit LPG2, the inductors L21 and L22 and the capacitors C21, C22, and C23 constitute the low-pass filter LP21 that performs the low-pass filter processing on the U-phase voltage transmitted by the U-phase power line 51. The U-phase voltage subjected to the low-pass filter processing in the low-pass filter LP21 is supplied to the brushless motor. The U-phase voltage subjected to the low-pass filter processing in the low-pass filter LP21 is not a sine wave voltage but is a square wave voltage including a fundamental wave component and a harmonic component (specifically, a harmonic component attenuated further than the time before being subjected to the low-pass filter processing). The order of the low-pass filter LP21 is odd order, for example. Specifically, the order of the low-pass filter LP21 is third order.

In the low-pass filter unit LPG2, the inductors L23 and L24 and the capacitors C21, C22, and C23 constitute the low-pass filter LP22 that performs the low-pass filter processing on the V-phase voltage transmitted by the V-phase power line 52. The V-phase voltage subjected to the low-pass filter processing in the low-pass filter LP22 is supplied to the brushless motor. The V-phase voltage subjected to the low-pass filter processing in the low-pass filter LP22 is not a sine wave voltage but is a square wave voltage including a fundamental wave component and a harmonic component. The order of the low-pass filter LP22 is odd order, for example. Specifically, the order of the low-pass filter LP22 is third order.

In the low-pass filter unit LPG2, the inductors L25 and L26 and the capacitors C21, C22, and C23 constitute the low-pass filter LP23 that performs the low-pass filter processing on the W-phase voltage transmitted by the W-phase power line 53. The W-phase voltage subjected to the low-pass filter processing in the low-pass filter LP23 is supplied to the motor. The W-phase voltage subjected to the low-pass filter processing in the low-pass filter LP23 is not a sine wave voltage but is a square wave voltage including a fundamental wave component and a harmonic component. The order of the low-pass filter LP23 is odd order, for example. Specifically, the order of the low-pass filter LP23 is third order.

As described above, in the interface circuit 24, the low-pass filters LP21, LP22, and LP23 perform the low-pass filter processing on the U-phase voltage, the V-phase voltage, and the W-phase voltage, and thus the harmonic components included in the U-phase voltage, the V-phase voltage, and the W-phase voltage are attenuated. Accordingly, high-frequency noise due to the U-phase voltage, the V-phase voltage, and the W-phase voltage is less easily transmitted to the load 21.

Even if high-frequency noise is generated in at least one of the load-side communication unit 23 and the power supply-side communication unit 13, the high-frequency noise is less easily transmitted to the load 21 owing to the low-pass filters LP21 and LP22.

Even if high-frequency noise is generated in the load 21, the high-frequency noise is less easily transmitted to the load-side communication unit 23 owing to the low-pass filters LP21 and LP22, and thus the communication quality can be enhanced. Even if high-frequency noise is generated in the load 21, the high-frequency noise is less easily transmitted to the power supply-side system 10 owing to the low-pass filters LP21, LP22, and LP23. For example, the high-frequency noise is less easily transmitted to the power supply unit 11. The high-frequency noise is less easily transmitted to the power supply-side communication unit 13, and thus the communication quality can be enhanced.

In the present example, the couplers CP21 and CP22 of the coupler unit CPG2 function as the high-pass filters HP21 and HP22, and thus even if low-frequency noise is generated in the load-side communication unit 23, the low-frequency noise is less easily superimposed on the U-phase power line 51 and the V-phase power line 52. Accordingly, the low-frequency noise is less easily transmitted to the load 21 and the power supply-side system 10. With the low-frequency noise being less easily transmitted to the power supply-side communication unit 13 of the power supply-side system 10, the communication quality can be enhanced. Even if low-frequency noise is generated in at least one of the load 21 and the power supply-side system 10, the low-frequency noise is less easily transmitted to the load-side communication unit 23, and thus the communication quality can be enhanced.

In the present example, the low-pass filter LP21 inserted into the U-phase power line 51 includes the inductors L21 and L22 at its both ends. The inductor L22 on the coupler CP21 side functions as an impedance increaser for the load-side communication signal to be superimposed on the U-phase power line 51 by the coupler CP21, and thus the load-side communication signal superimposed on the U-phase power line 51 is less easily transmitted toward the load 21. Accordingly, the signal level of the load-side communication signal input to the power supply-side communication unit 13 via the U-phase power line 51 is less easily reduced, and thus the communication quality can be enhanced. Owing to the inductor L22, the power supply-side communication signal superimposed on the U-phase power line 51 is less easily transmitted toward the load 21. Accordingly, the signal level of the power supply-side communication signal input to the load-side communication unit 23 via the U-phase power line 51 is less easily reduced, and thus the communication quality can be enhanced. On the other hand, the inductor L21 is present on the load 21 side, and thus even if impedance seen from the side of the low-pass filter LP21 of the load 21 is low, the low-pass filter LP21 can appropriately attenuate the high-frequency noise output from the load 21.

In the present example, the low-pass filter LP22 inserted into the V-phase power line 52 includes the inductors L23 and L24 at its both ends. The inductor L24 on the coupler CP22 side functions as an impedance increaser for the load-side communication signal to be superimposed on the V-phase power line 52 by the coupler CP22, and thus the load-side communication signal superimposed on the V-phase power line 52 is less easily transmitted toward the load 21. Accordingly, the signal level of the load-side communication signal input to the power supply-side communication unit 13 via the V-phase power line 52 is less easily reduced, and thus the communication quality can be enhanced. Owing to the inductor L24, the power supply-side communication signal superimposed on the V-phase power line 52 is less easily transmitted toward the load 21. Accordingly, the signal level of the power supply-side communication signal input to the load-side communication unit 23 via the V-phase power line 52 is less easily reduced, and thus the communication quality can be enhanced. On the other hand, the inductor L23 is present on the load 21 side, and thus even if impedance seen from the side of the low-pass filter LP22 of the load 21 is low, the low-pass filter LP22 can appropriately attenuate the high-frequency noise output from the load 21.

### <Example of Gain Frequency Characteristics of Low-Pass Filters and High-Pass Filters>

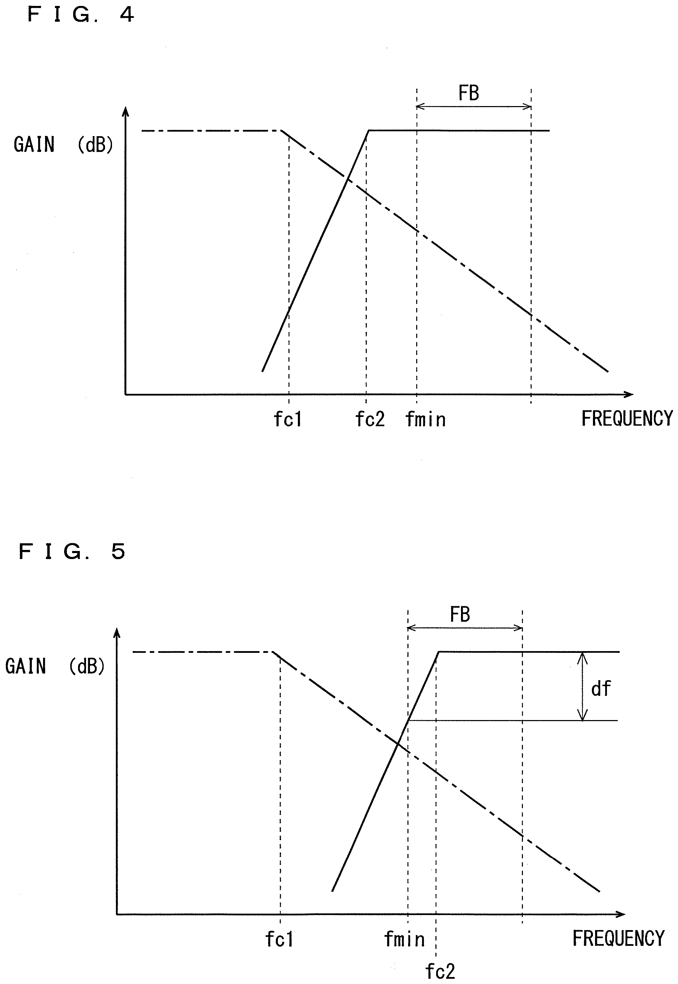

FIG. 4 is a schematic diagram illustrating an example of gain frequency characteristics of the low-pass filters LP11, LP12, LP13, LP21, LP22, and LP23 and an example of gain frequency characteristics of the high-pass filters HP11, HP12, HP21, and HP22. The gain frequency characteristics are also referred to as amplitude frequency characteristics. The gain frequency characteristics of the low-pass filters LP11, LP12, LP13, LP21, LP22, and LP23 are the same as each other, for example. The gain frequency characteristics of the high-pass filters HP11, HP12, HP21, and HP22 are the same as each other, for example. In FIG. 4, the example of the gain frequency characteristics of the low-pass filters LP11, LP12, LP13, LP21, LP22, and LP23 is indicated by the chain line, and the example of the gain frequency characteristics of the high-pass filters HP11, HP12, HP21, and HP22 is indicated by the solid line.

A cutoff frequency fc2 (also referred to as an HPF cutoff frequency fc2) of the high-pass filters HP11, HP12, HP21, and HP22 is set to a lower limit value fmin or less of a frequency band of the power supply-side differential signal and the load-side differential signal (i.e., a frequency band of the power supply-side communication signal and the load-side communication signal) FB, for example. In the example of FIG. 4, the HPF cutoff frequency fc2 is set lower than the lower limit value fmin of the frequency band FB (also referred to as the communication frequency band FB) of the power supply-side differential signal and the load-side differential signal.

The lower limit value fmin of the communication frequency band FB is set higher than the frequency (for example, several kHz) of the fundamental wave component of the U-phase voltage, the V-phase voltage, and the W-phase voltage. The lower limit value fmin may be set 1000 times as high as or higher than the frequency of the fundamental wave component of the U-phase voltage, the V-phase voltage, and the W-phase voltage (which is also simply referred to as the fundamental wave component), may be set 5000 times as high as or higher than the frequency, may be set 10000 times as high as or higher than the frequency, or may be set 50000 times as high as or higher than the frequency, for example. The communication frequency band FB is set from 50 MHz to 90 MHz, for example. In this case, the HPF cutoff frequency fc2 is set to 50 MHz or less. The HPF cutoff frequency fc2 may be set to 45 MHz, for example.

A cutoff frequency fc1 (also referred to as an LPF cutoff frequency fc1) of the low-pass filters LP11, LP12, LP13, LP21, LP22, and LP23 is set to the frequency (for example, several kHz) or higher of the fundamental wave component, for example. The LPF cutoff frequency fc1 is set to the lower limit value fmin or less of the communication frequency band FB, for example. For example, the LPF cutoff frequency fc1 may be set to the HPF cutoff frequency fc2 or less. In the example of FIG. 4, the LPF cutoff frequency fc1 is set lower than the HPF cutoff frequency fc2. The LPF cutoff frequency fc1 may be set to 20 MHz, for example.

Note that the LPF cutoff frequency fc1 may be one-third or less of the lower limit value fmin (for example, 50 MHz) of the communication frequency band FB, may be one-fourth or less thereof, or may be one-fifth or less thereof.

A difference between the HPF cutoff frequency fc2 and the LPF cutoff frequency fc1 may be a half or more of the width of the communication frequency band FB (i.e., the frequency bandwidth of the power supply-side differential signal and the load-side differential signal), may be one-third or less thereof, or may be one-fourth or less thereof. For example, when the HPF cutoff frequency fc2 is 45 MHz, the LPF cutoff frequency fc1 is 20 MHz, and the width of the communication frequency band FB is 40 MHz, the difference between the HPF cutoff frequency fc2 and the LPF cutoff frequency fc1 is a half or more of the width of the communication frequency band FB.

Note that the difference between the HPF cutoff frequency fc2 and the LPF cutoff frequency fc1 may be two-thirds or more of the width of the communication frequency band FB, may be three-fourths or more thereof, or may be the width of the communication frequency band FB or more. By increasing the difference between the HPF cutoff frequency fc2 and the LPF cutoff frequency fc1, noise input to the communication unit 13, the communication unit 23, the power supply unit 11, and the load 21 can be reduced.

In this manner, when the LPF cutoff frequency fc1 is set to the lower limit value fmin or less of the communication frequency band FB, noise generated in at least one of the power supply unit 11 and the load 21 and having a frequency in the communication frequency band FB is less easily input to the communication unit 13 and the communication unit 23. Thus, the communication quality can be enhanced.

When the LPF cutoff frequency fc1 is one-third or less of the lower limit value fmin of the communication frequency band FB, the noise generated in at least one of the power supply unit 11 and the load 21 and having a frequency in the communication frequency band FB is much less easily input to the communication unit 13 and the communication unit 23, and thus the communication quality can be further enhanced.

As in the example of FIG. 4, when the LPF cutoff frequency fc1 is lower than the HPF cutoff frequency fc2 being equal to or less than the lower limit value fmin of the communication frequency band FB, the noise generated in at least one of the power supply unit 11 and the load 21 and having a frequency in the communication frequency band FB is much less easily input to the communication unit 13 and the communication unit 23. Thus, the communication quality can be further enhanced.

When the difference between the HPF cutoff frequency fc2 and the LPF cutoff frequency fc1 is a half or more of the width of the communication frequency band FB, the noise generated in at least one of the power supply unit 11 and the load 21 and having a frequency in the communication frequency band FB is much less easily input to the communication unit 13 and the communication unit 23. Thus, the communication quality can be further enhanced.

In the present example, the order (also referred to as LPF order) of the low-pass filters LP11, LP12, LP13, LP21, LP22, and LP23 is set higher than the order (also referred to as HPF order) of the high-pass filters HP11, HP12, HP21, and HP22. In this manner, by setting the LPF order higher than the HPF order, an attenuation factor of the low-pass filters LP11, LP12, LP13, LP21, LP22, and LP23 is increased, and thus the communication frequency band FB can be reduced because the communication quality can be maintained even if the communication frequency band FB is reduced, for example. By reducing the communication frequency band FB, the cable 60 can be extended, and thus a communication distance between the power supply-side communication unit 13 and the load-side communication unit 23 can be increased. By increasing the LPF order, noise is reduced, and thus radiation noise of the processing system 1A can be reduced.

Note that, as illustrated in FIG. 5, the HPF cutoff frequency fc2 may be set higher than the lower limit value fmin of the communication frequency band FB. In this case, in the gain frequency characteristics of the high-pass filters HP11, HP12, HP21, and HP22, when an absolute value df of a difference between a gain (i.e., 0 dB) in a passband and a gain at the lower limit value fmin of the communication frequency band FB is set to a predetermined value or less, the communication quality between the power supply-side communication unit 13 and the load-side communication unit 23 can be made satisfactory. Alternatively, in the gain frequency characteristics of the high-pass filters HP11, HP12, HP21, and HP22, when the absolute value of a difference between a gain (i.e., -3 dB) in the HPF cutoff frequency fc2 and a gain at the lower limit value fmin of the communication frequency band FB is set to a predetermined value or less, the communication quality can be made satisfactory. When the modulation scheme in the power supply-side communication unit 13 and the load-side communication unit 23 is QPSK or FSK, the predetermined value may be set to 20 dB, for example.

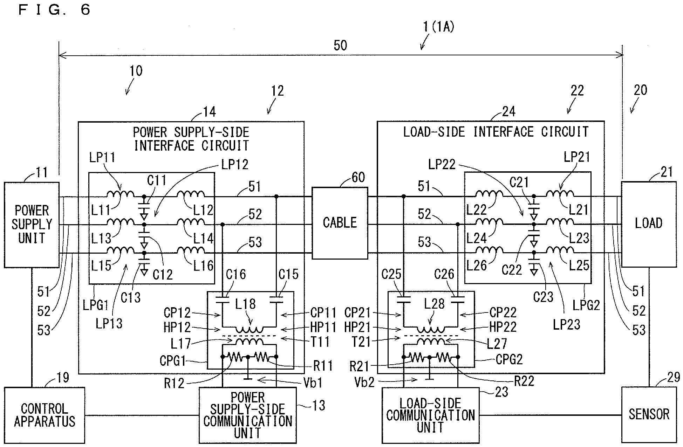

As in the example of FIG. 6, the other ends of the capacitors C11, C12, and C13 may be connected to the ground (for example, the ground of the power supply unit 11), or may be connected to the earth. The other ends of the capacitors C21, C22, and C23 may be connected to the ground (for example, the ground of the load 21), or may be connected to the earth.

In the above example, the LPF order is third order, but may be odd order of fifth order or higher. When the LPF order is odd order of third order or higher, inductors can be provided at both ends of each of the low-pass filters LP11, LP12, LP13, LP21, LP22, and LP23. The LPF order may be even order.

In the above example, the HPF order is second order, but may be odd order of third order or higher, or may be even order of fourth order or higher. The HPF order may be the same as the LPF order, or may be higher than the LPF order.

In the above example, the gain frequency characteristics of the low-pass filters LP11, LP12, LP13, LP21, LP22, and LP23 are the same as each other, but the gain frequency characteristics of at least two low-pass filters of the low-pass filters LP11, LP12, LP13, LP21, LP22, and LP23 may be different from each other. The cutoff frequencies of at least two low-pass filters of the low-pass filters LP11, LP12, LP13, LP21, LP22, and LP23 may be different from each other.

In the above example, the orders of the low-pass filters LP11, LP12, LP13, LP21, LP22, and LP23 are the same as each other, but the orders of at least two low-pass filters of the low-pass filters LP11, LP12, LP13, LP21, LP22, and LP23 may be different from each other.

In the above example, the gain frequency characteristics of the high-pass filters HP11, HP12, HP21, and HP22 are the same as each other, but the gain frequency characteristics of at least two high-pass filters of the high-pass filters HP11, HP12, HP21, and HP22 may be different from each other. The cutoff frequencies of at least two high-pass filters of the high-pass filters HP11, HP12, HP21, and HP22 may be different from each other.

In the above example, the orders of the high-pass filters HP11, HP12, HP21, and HP22 are the same as each other, but the orders of at least two high-pass filters of the high-pass filters HP11, HP12, HP21, and HP22 may be different from each other.

The constant of the inductor L12 of the power supply-side interface circuit 14 and the constant of the inductor L22 of the load-side interface circuit 24 may be different from each other. For example, the constant of the inductor L12 may be set larger than the constant of the inductor L22. In this case, high-frequency noise due to the U-phase voltage output by the power supply unit 11 can be made less easily transmitted to the load-side system 20. On the other hand, when the constant of the inductor L22 is set larger than the constant of the inductor L12, high-frequency noise generated in the load 21 can be made less easily transmitted to the power supply-side system 10 via the U-phase power line 51.

Similarly, the constant of the inductor L14 of the power supply-side interface circuit 14 and the constant of the inductor L24 of the load-side interface circuit 24 may be different from each other. The constant of the inductor L16 of the power supply-side interface circuit 14 and the constant of the inductor L26 of the load-side interface circuit 24 may be different from each other.

In the load-side interface circuit 24, the low-pass filter unit LPG2 need not be provided. In the power supply-side interface circuit 14, the low-pass filter unit LPG1 need not be provided.

The power supply-side communication unit 13 and the load-side communication unit 23 may perform single-ended communication. In this case, the communication signal (also referred to as a power supply-side single-ended signal) in single-ended form output by the power supply-side communication unit 13 is superimposed on one of the U-phase power line 51, the V-phase power line 52, and the W-phase power line 53. The communication signal (also referred to as a load-side single-ended signal) in single-ended form output by the load-side communication unit 23 is superimposed on one of the U-phase power line 51, the V-phase power line 52, and the W-phase power line 53.

When the power supply-side single-ended signal is superimposed on the U-phase power line 51, for example, in the coupler unit CPG1, the capacitor C16 is unnecessary, and one end of the primary-side coil L17 and one end of the secondary-side coil L18 are connected to the ground. When the load-side single-ended signal is superimposed on the U-phase power line 51, for example, in the coupler unit CPG2, the capacitor C26 is unnecessary, and one end of the primary-side coil L27 and one end of the secondary-side coil L28 are connected to the ground.

The coupler unit CPG1 need not include the isolation transformer T11. In this case, one end of the capacitor C15 is connected to the power supply-side communication unit 13 and one end of the resistor R11, and one end of the capacitor C16 is connected to the power supply-side communication unit 13 and one end of the resistor R12. The coupler unit CPG2 need not include the isolation transformer T21. In this case, one end of the capacitor C25 is connected to the load-side communication unit 23 and one end of the resistor R21, and one end of the capacitor C26 is connected to the load-side communication unit 23 and one end of the resistor R22.

### <Other Examples of Processing Systems>

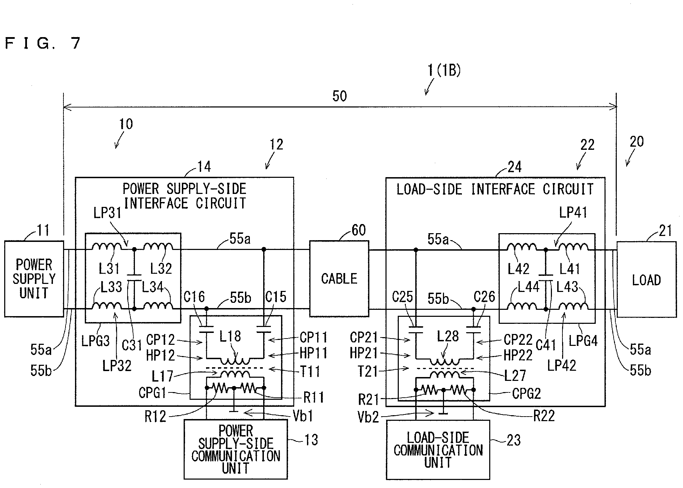

FIG. 7 is a schematic diagram illustrating an example of the processing system 1 when the load 21 is a brushed DC motor. In the following, the term "brushed DC motor" or the term "brushed motor" means the brushed DC motor as the load 21.

In the processing system 1 (also referred to as a processing system 1B) illustrated in FIG. 7, the power supply unit 11 outputs the power supply voltage of the brushed DC motor. The brushed DC motor is subjected to PWM control, for example. The brushed DC motor can rotate in both directions on the power supply voltage supplied from the power supply unit 11. In the following, both of the directions in which the brushed DC motor can rotate are referred to as a first direction and a second direction.

The power line 50 transmits the power supply voltage output from the power supply unit 11 to the brushed DC motor. The power line 50 includes a first power line 55a and a second power line 55b. The first power line 55a extends from the power supply unit 11 to one electrode (also referred to as one brush) of the brushed DC motor. The second power line 55b extends from the power supply unit 11 to the other electrode (also referred to as the other brush) of the brushed DC motor.

The power supply unit 11 includes an H-bridge circuit (also referred to as a half bridge circuit), for example. The H-bridge circuit can output the power supply voltage of a square wave to each of the first power line 55a and the second power line 55b. When the H-bridge circuit rotates the brushed motor in the first direction, the H-bridge circuit outputs a first power supply voltage of a square wave to the first power line 55a, and connects the second power line 55b to the ground of the power supply unit 11. On the other hand, when the H-bridge circuit rotates the brushed motor in the second direction, the H-bridge circuit outputs a second power supply voltage of a square wave to the second power line 55b, and connects the first power line 55a to the ground of the power supply unit 11. The maximum value of the first power supply voltage and the second power supply voltage is several hundred volts, for example.

The first power line 55a transmits the first power supply voltage output by the power supply unit 11 to the one electrode of the brushed motor. When the first power supply voltage of a square wave is supplied to the one electrode of the brushed DC motor, the other electrode connected to the second power line 55b in the brushed motor is connected to the ground. The second power line 55b transmits the second power supply voltage output by the power supply unit 11 to the other electrode of the brushed motor. When the second power supply voltage of a square wave is supplied to the other electrode of the brushed DC motor, the one electrode connected to the first power line 55a in the brushed motor is connected to the ground.

The power supply-side interface circuit 14 included in the processing system 1B includes a low-pass filter unit LPG3 including low-pass filters LP31 and LP32 and the above-described coupler unit CPG1, for example. The load-side interface circuit 24 included in the processing system 1B includes a low-pass filter unit LPG4 including low-pass filters LP41 and LP42 and the above-described coupler unit CPG2, for example.

The other ends of the capacitors C15 and C16 of the coupler unit CPG1 are respectively connected to the first power line 55a and the second power line 55b. The coupler unit CPG1 superimposes the power supply-side differential signal output by the power supply-side communication unit 13 on the first power line 55a and the second power line 55b. One power supply-side communication signal of the power supply-side differential signal output from the secondary-side coil L18 is superimposed on the first power line 55a via the capacitor C15 of the coupler CP11. The other power supply-side communication signal of the power supply-side differential signal output from the secondary-side coil L18 is superimposed on the second power line 55b via the capacitor C16 of the coupler CP12.

The other ends of the capacitors C25 and C26 of the coupler unit CPG2 are respectively connected to the first power line 55a and the second power line 55b. The coupler unit CPG2 superimposes the load-side differential signal output by the load-side communication unit 23 on the first power line 55a and the second power line 55b. One load-side communication signal of the load-side differential signal output from the secondary-side coil L28 is superimposed on the first power line 55a via the capacitor C25 of the coupler CP21. The other load-side communication signal of the load-side differential signal output from the secondary-side coil L28 is superimposed on the second power line 55b via the capacitor C26 of the coupler CP22.

The coupler unit CPG1 extracts the load-side differential signal from the first power line 55a and the second power line 55b on which the load-side differential signal is superimposed, and outputs the load-side differential signal to the power supply-side communication unit 13. The one load-side communication signal superimposed on the first power line 55a is input to the other end of the capacitor C15 of the coupler CP11, and the other load-side communication signal superimposed on the second power line 55b is input to the other end of the capacitor C16 of the coupler CP12.

The coupler unit CPG2 extracts the power supply-side differential signal from the first power line 55a and the second power line 55b on which the power supply-side differential signal is superimposed, and outputs the power supply-side differential signal to the load-side communication unit 23. The one power supply-side communication signal superimposed on the first power line 55a is input to the other end of the capacitor C25 of the coupler CP21, and the other power supply-side communication signal superimposed on the second power line 55b is input to the other end of the capacitor C26 of the coupler CP22.

The one power supply-side communication signal subjected to the high-pass filter processing in the high-pass filter HP11 including the coupler CP11 is superimposed on the first power line 55a. The high-pass filter HP11 performs the high-pass filter processing on the one load-side communication signal extracted from the first power line 55a, and outputs the one load-side communication signal to the power supply-side communication unit 13.

The other power supply-side communication signal subjected to the high-pass filter processing in the high-pass filter HP12 including the coupler CP12 is superimposed on the second power line 55b. The high-pass filter HP12 performs the high-pass filter processing on the other load-side communication signal extracted from the second power line 55b, and outputs the other load-side communication signal to the power supply-side communication unit 13.

The one load-side communication signal subjected to the high-pass filter processing in the high-pass filter HP21 including the coupler CP21 is superimposed on the first power line 55a. The high-pass filter HP21 performs the high-pass filter processing on the one power supply-side communication signal extracted from the first power line 55a, and outputs the one power supply-side communication signal to the load-side communication unit 23.

The other load-side communication signal subjected to the high-pass filter processing in the high-pass filter HP22 including the coupler CP22 is superimposed on the second power line 55b. The high-pass filter HP22 performs the high-pass filter processing on the other power supply-side communication signal extracted from the second power line 55b, and outputs the other power supply-side communication signal to the load-side communication unit 23.

The low-pass filter unit LPG3 includes inductors L31, L32, L33, and L34 and a capacitor C31, for example. The inductors L31 and L32 are connected to each other in series, and are inserted into the first power line 55a. One end of the inductor L31 is connected to the power supply unit 11, and the other end of the inductor L31 is connected to one end of the inductor L32. The other end of the inductor L32 is connected to the other end of the capacitor C15 of the coupler CP11 and the cable 60. The first power supply voltage output by the power supply unit 11 is input to the one end of the inductor L31.

The inductors L33 and L34 are connected to each other in series, and are inserted into the second power line 55b. One end of the inductor L33 is connected to the power supply unit 11, and the other end of the inductor L33 is connected to one end of the inductor L34. The other end of the inductor L34 is connected the other end of the capacitor C16 of the coupler CP12 and the cable 60. The second power supply voltage output by the power supply unit 11 is input to the one end of the inductor L33.

One end of the capacitor C31 is connected to the other end of the inductor L31 and the one end of the inductor L32. The other end of the capacitor C31 is connected to the other end of the inductor L33 and the one end of the inductor L34.

In the low-pass filter unit LPG3, the inductors L31 and L32 and the capacitor C31 constitute the low-pass filter LP31 that performs the low-pass filter processing on the first power supply voltage transmitted by the first power line 55a. The first power supply voltage subjected to the low-pass filter processing in the low-pass filter LP31 is transmitted to the load-side system 20 via the cable 60. The order of the low-pass filter LP31 is third order, for example.

In the low-pass filter unit LPG3, the inductors L33 and L34 and the capacitor C31 constitute the low-pass filter LP32 that performs the low-pass filter processing on the second power supply voltage transmitted by the second power line 55b. The second power supply voltage subjected to the low-pass filter processing in the low-pass filter LP32 is transmitted to the load-side system 20 via the cable 60. The order of the low-pass filter LP32 is third order, for example.

The low-pass filter unit LPG4 includes inductors L41, L42, L43, and L44 and a capacitor C41, for example. The inductors L41 and L42 are connected to each other in series, and are inserted into the first power line 55a. One end of the inductor L41 is connected to the one electrode of the brushed motor, and the other end of the inductor L41 is connected to one end of the inductor L42. The other end of the inductor L42 is connected to the other end of the capacitor C25 of the coupler CP21 and the cable 60. The first power supply voltage transmitted to the load-side system 20 via the cable 60 is input to the other end of the inductor L42.

The inductors L43 and L44 are connected to each other in series, and are inserted into the second power line 55b. One end of the inductor L43 is connected to the other electrode of the brushed motor, and the other end of the inductor L43 is connected to one end of the inductor L44. The other end of the inductor L44 is connected to the other end of the capacitor C26 of the coupler CP22 and the cable 60. The second power supply voltage transmitted to the load-side system 20 via the cable 60 is input to the other end of the inductor L44.

One end of the capacitor C41 is connected to the other end of the inductor L41 and the one end of the inductor L42. The other end of the capacitor C41 is connected to the other end of the inductor L43 and the one end of the inductor L44.

In the low-pass filter unit LPG4, the inductors L41 and L42 and the capacitor C41 constitute the low-pass filter LP41 that performs the low-pass filter processing on the first power supply voltage transmitted by the first power line 55a. The first power supply voltage subjected to the low-pass filter processing in the low-pass filter LP41 is supplied to the one electrode of the brushed motor. The order of the low-pass filter LP41 is third order, for example.

In the low-pass filter unit LPG4, the inductors L43 and L44 and the capacitor C41 constitute the low-pass filter LP42 that performs the low-pass filter processing on the second power supply voltage transmitted by the second power line 55b. The second power supply voltage subjected to the low-pass filter processing in the low-pass filter LP42 is supplied to the other electrode of the brushed motor. The order of the low-pass filter LP42 is third order, for example.

As described above, in the power supply-side interface circuit 14 of the processing system 1B, the low-pass filters LP31 and LP32 perform the low-pass filter processing on the first power supply voltage and the second power supply voltage of a square wave, and thus the harmonic components included in the first power supply voltage and the second power supply voltage are attenuated. Accordingly, high-frequency noise due to the first power supply voltage and the second power supply voltage is less easily transmitted to the power supply-side communication unit 13 and the load-side system 20.

Even if high-frequency noise is generated in at least one of the power supply-side communication unit 13 and the load-side system 20, the high-frequency noise is less easily transmitted to the power supply unit 11 owing to the low-pass filter unit LPG3.

In the present example, the couplers CP11 and CP12 function as the high-pass filters HP11 and HP12, and thus even if low-frequency noise is generated in the power supply-side communication unit 13, the low-frequency noise is less easily superimposed on the first power line 55a and the second power line 55b. Accordingly, the low-frequency noise is less easily transmitted to the power supply unit 11 and the load-side system 20. Even if low-frequency noise is generated in at least one of the power supply unit 11 and the load-side system 20, the low-frequency noise is less easily transmitted to the power supply-side communication unit 13.

In the present example, the low-pass filter LP31 inserted into the first power line 55a includes the inductors L31 and L32 at its both ends. The inductor L32 on the coupler CP11 side functions as an impedance increaser for the power supply-side communication signal to be superimposed on the first power line 55a by the coupler CP11, and thus the power supply-side communication signal superimposed on the first power line 55a is less easily transmitted toward the power supply unit 11. Accordingly, the signal level of the power supply-side communication signal input to the load-side communication unit 23 via the first power line 55a is less easily reduced. The inductor L32 functions as an impedance increaser for the load-side communication signal to be superimposed on the first power line 55a by the coupler CP21, and thus the load-side communication signal superimposed on the first power line 55a is less easily transmitted toward the power supply unit 11. Accordingly, the signal level of the load-side communication signal input to the power supply-side communication unit 13 via the first power line 55a is less easily reduced. On the other hand, the inductor L31 is present on the power supply unit 11 side, and thus even if output impedance of the power supply unit 11 is low, the low-pass filter LP31 can appropriately attenuate the harmonic component included in the first power supply voltage output from the power supply unit 11. It can be said that the same applies to the low-pass filter LP32 inserted into the second power line 55b.

In the load-side interface circuit 24, the low-pass filters LP41 and LP42 perform the low-pass filter processing on the first power supply voltage and the second power supply voltage of a square wave, and thus the harmonic components included in the first power supply voltage and the second power supply voltage are attenuated. Accordingly, high-frequency noise due to the first power supply voltage and the second power supply voltage is less easily transmitted to the load 21.

Even if high-frequency noise is generated in at least one of the load-side communication unit 23 and the power supply-side communication unit 13, the high-frequency noise is less easily transmitted to the load 21 owing to the low-pass filters LP41 and LP42.

Even if high-frequency noise is generated in the load 21, the high-frequency noise is less easily transmitted to the load-side communication unit 23 and the power supply-side system 10 owing to the low-pass filter unit LPG4.

In the present example, the couplers CP21 and CP22 function as the high-pass filters HP21 and HP22, and thus even if low-frequency noise is generated in the load-side communication unit 23, the low-frequency noise is less easily superimposed on the first power line 55a and the second power line 55b. Accordingly, the low-frequency noise is less easily transmitted to the load 21 and the power supply-side system 10. Even if low-frequency noise is generated in at least one of the load 21 and the power supply-side system 10, the low-frequency noise is less easily transmitted to the load-side communication unit 23.

In the present example, the low-pass filter LP41 inserted into the first power line 55a includes the inductors L41 and L42 at its both ends. The inductor L42 on the coupler CP21 side functions as an impedance increaser for the load-side communication signal to be superimposed on the first power line 55a by the coupler CP21, and thus the load-side communication signal superimposed on the first power line 55a is less easily transmitted toward the load 21. Accordingly, the signal level of the load-side communication signal input to the power supply-side communication unit 13 via the first power line 55a is less easily reduced. The inductor L42 functions as an impedance increaser for the power supply-side communication signal to be superimposed on the first power line 55a by the coupler CP11, and thus the power supply-side communication signal superimposed on the first power line 55a is less easily transmitted toward the load 21. Accordingly, the signal level of the power supply-side communication signal input to the load-side communication unit 23 via the first power line 55a is less easily reduced. On the other hand, the inductor L41 is present on the load 21 side, and thus even if impedance seen from the side of the low-pass filter LP41 of the load 21 is low, the low-pass filter LP41 can appropriately attenuate the high-frequency noise output from the load 21. It can be said that the same applies to the low-pass filter LP42 inserted into the second power line 55b.

The gain frequency characteristics of the low-pass filters LP31, LP32, LP41, and LP42 may be the same as each other. The cutoff frequencies of the low-pass filters LP31, LP32, LP41, and LP42 may be the same as each other.

In the processing system 1B, the lower limit value fmin of the communication frequency band FB is set higher than the frequency (for example, several kHz) of the fundamental wave component included in the first power supply voltage and the second power supply voltage of a square wave. The lower limit value fmin may be set 1000 times as high as or higher than the frequency of the fundamental wave component included in the first power supply voltage and the second power supply voltage, may be set 5000 times as high as or higher than the frequency, may be set 10000 times as high as or higher than the frequency, or may be set 50000 times as high as or higher than the frequency, for example.

A cutoff frequency (also referred to as a second LPF cutoff frequency) of the low-pass filters LP31, LP32, LP41, and LP42 is set to the frequency or higher of the fundamental wave component included in the first power supply voltage and the second power supply voltage, for example. A relationship between the second LPF cutoff frequency and the lower limit value fmin of the communication frequency band FB may be the same as the above-described relationship between the LPF cutoff frequency fc1 and the lower limit value fmin of the communication frequency band FB. A relationship between the second LPF cutoff frequency and the HPF cutoff frequency fc2 (i.e., the cutoff frequency of the high-pass filters HP11, HP12, HP21, and HP22) may be the same as the above-described relationship between the LPF cutoff frequency fc1 and the HPF cutoff frequency fc2. A relationship between the HPF cutoff frequency fc2 and the lower limit value fmin of the communication frequency band FB in the processing system 1B may be the same as the relationship (for example, FIG. 4 or FIG. 5) between the HPF cutoff frequency fc2 and the lower limit value fmin of the communication frequency band FB in the processing system 1A.

Note that the other end of the capacitor C31 may be connected to the ground or may be connected to the earth. In this case, an additional capacitor connected to a connecting point between the inductor L33 and the inductor L34 may be provided. One end of the additional capacitor may be connected to the connecting point between the inductor L33 and the inductor L34, and the other end of the additional capacitor may be connected to the ground or may be connected to the earth.

Similarly, the other end of the capacitor C41 may be connected to the ground or may be connected to the earth. In this case, an additional capacitor connected to a connecting point between the inductor L43 and the inductor L44 may be provided. One end of the additional capacitor may be connected to the connecting point between the inductor L43 and the inductor L44, and the other end of the additional capacitor may be connected to the ground or may be connected to the earth.

The order of the low-pass filters LP31, LP32, LP41, and LP42 may be odd order of fifth order or higher, or may be even order. The gain frequency characteristics of at least two low-pass filters of the low-pass filters LP31, LP32, LP41, and LP42 may be different from each other. The cutoff frequencies of at least two low-pass filters of the low-pass filters LP31, LP32, LP41, and LP42 may be different from each other. The orders of at least two low-pass filters of the low-pass filters LP31, LP32, LP41, and LP42 may be different from each other.

The constant of the inductor L32 of the power supply-side interface circuit 14 and the constant of the inductor L42 of the load-side interface circuit 24 may be different from each other. The constant of the inductor L32 may be set larger than the constant of the inductor L42, and the constant of the inductor L42 may be set larger than the constant of the inductor L32. Similarly, the constant of the inductor L34 of the power supply-side interface circuit 14 and the constant of the inductor L44 of the load-side interface circuit 24 may be different from each other.

In the load-side interface circuit 24, the low-pass filter unit LPG4 need not be provided. In the power supply-side interface circuit 14, the low-pass filter unit LPG3 need not be provided.

The power supply-side communication unit 13 and the load-side communication unit 23 may perform single-ended communication. In this case, the power supply-side single-ended signal output by the power supply-side communication unit 13 is superimposed on one of the first power line 55a and the second power line 55b. The load-side single-ended signal output by the load-side communication unit 23 is superimposed on one of the first power line 55a and the second power line 55b. When the power supply-side single-ended signal is superimposed on the first power line 55a, for example, in the coupler unit CPG1, the capacitor C16 is unnecessary, and one end of the primary-side coil L17 and one end of the secondary-side coil L18 are connected to the ground. When the load-side single-ended signal is superimposed on the first power line 55a, for example, in the coupler unit CPG2, the capacitor C26 is unnecessary, and one end of the primary-side coil L27 and one end of the secondary-side coil L28 are connected to the ground.

In the processing system 1B as well, the coupler unit CPG1 need not include the isolation transformer T11. In this case, one end of the capacitor C15 is connected to the power supply-side communication unit 13 and one end of the resistor R11, and one end of the capacitor C16 is connected to the power supply-side communication unit 13 and one end of the resistor R12. The coupler unit CPG2 need not include the isolation transformer T21. In this case, one end of the capacitor C25 is connected to the load-side communication unit 23 and one end of the resistor R21, and one end of the capacitor C26 is connected to the load-side communication unit 23 and one end of the resistor R22.

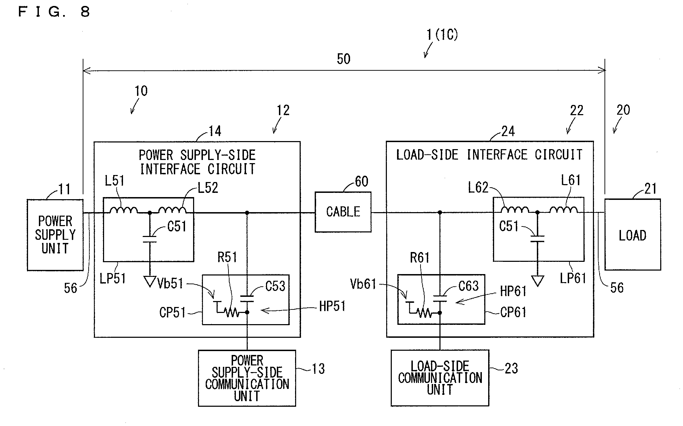

FIG. 8 is a schematic diagram illustrating another example of the processing system 1 when the load 21 is a brushed DC motor. In the processing system 1 (also referred to as a processing system 1C) illustrated in FIG. 8, the power line 50 includes a single power line 56.

In the processing system 1 (also referred to as the processing system 1C) illustrated in FIG. 8, the power line 56 transmits the power supply voltage output from the power supply unit 11 to the brushed DC motor. The power line 56 extends from the power supply unit 11 to one electrode of the brushed DC motor. The other electrode of the brushed DC motor is connected to the ground.

In the processing system 1C as well, the brushed DC motor as the load 21 is subjected to PWM control, for example. The power supply unit 11 includes a T-bridge circuit, for example. The T-bridge circuit can output the power supply voltage of a square wave to the power line 56. When the T-bridge circuit rotates the brushed motor in the first direction, the T-bridge circuit outputs a positive power supply voltage of a square wave to the power line 56. The power line 56 transmits the positive power supply voltage output by the power supply unit 11 to the one electrode of the brushed motor. On the other hand, when the H-bridge circuit rotates the brushed motor in the second direction, the H-bridge circuit outputs a negative power supply voltage of a square wave to the power line 56. The power line 56 transmits the negative power supply voltage output by the power supply unit 11 to the one electrode of the brushed motor. The absolute value of the maximum value of the positive power supply voltage and the negative power supply voltage is several hundred volts, for example.

The power supply-side interface circuit 14 included in the processing system 1C includes a low-pass filter LP51 and a coupler CP51, for example. The load-side interface circuit 24 included in the processing system 1C includes a low-pass filter LP61 and a coupler CP61, for example.

In the processing system 1C, the power supply-side communication unit 13 and the load-side communication unit 23 perform single-ended communication, for example. The coupler CP51 superimposes the power supply-side single-ended signal transmitted by the communication unit 13 on the power line 56. The coupler CP61 superimposes the load-side single-ended signal transmitted by the communication unit 23 on the power line 56.

The coupler CP51 includes a capacitor C53 and a resistor R51, for example. One end of the capacitor C53 is connected to the communication unit 13 and one end of the resistor R51. A bias voltage Vb51 is applied to the other end of the resistor R51. The bias voltage Vb51 is applied to the one end of the capacitor C53 via the resistor R51. The other end of the capacitor C53 is connected to the power line 56. The power supply-side single-ended signal transmitted by the communication unit 13 is superimposed on the power line 56 via the capacitor C53.

The coupler CP61 includes a capacitor C63 and a resistor R61, for example. One end of the capacitor C63 is connected to the communication unit 23 and one end of the resistor R61. A bias voltage Vb61 is applied to the other end of the resistor R61. The bias voltage Vb61 is applied to the one end of the capacitor C63 via the resistor R61. The other end of the capacitor C63 is connected to the power line 56. The load-side single-ended signal transmitted by the communication unit 23 is superimposed on the power line 56 via the capacitor C63.

The coupler CP51 extracts the load-side single-ended signal from the power line 56 on which the load-side single-ended signal is superimposed, and outputs the load-side single-ended signal to the communication unit 13. The load-side single-ended signal superimposed on the power line 56 is input to the other end of the capacitor C53 of the coupler CP51. The load-side single-ended signal output from the one end of the capacitor C53 is input to the communication unit 13.

The coupler CP61 extracts the power supply-side single-ended signal from the power line 56 on which the power supply-side single-ended signal is superimposed, and outputs the power supply-side single-ended signal to the communication unit 23. The power supply-side single-ended signal superimposed on the power line 56 is input to the other end of the capacitor C63 of the coupler CP61. The power supply-side single-ended signal output from the one end of the capacitor C63 is input to the communication unit 23.

The coupler CP51 constitutes a high-pass filter HP51. In other words, the capacitor C53 and the resistor R51 constitute the high-pass filter HP51. The high-pass filter HP51 performs high-pass filter processing on the power supply-side single-ended signal transmitted by the communication unit 13. On the power line 56, the power supply-side single-ended signal subjected to the high-pass filter processing in the high-pass filter HP51 is superimposed. The high-pass filter HP51 performs high-pass filter processing on the load-side single-ended signal extracted from the power line 56. The load-side single-ended signal subjected to the high-pass filter processing in the high-pass filter HP51 is received in the communication unit 13.

The coupler CP61 constitutes a high-pass filter HP61. The high-pass filter HP61 performs high-pass filter processing on the load-side single-ended signal transmitted by the communication unit 23. On the power line 56, the load-side single-ended signal subjected to the high-pass filter processing in the high-pass filter HP61 is superimposed. The high-pass filter HP61 performs high-pass filter processing on the power supply-side single-ended signal extracted from the power line 56. The power supply-side single-ended signal subjected to the high-pass filter processing in the high-pass filter HP61 is received in the communication unit 23.

The order of the high-pass filters HP51 and HP61 is odd order, for example. Specifically, the order of the high-pass filters HP51 and HP61 is first order. The gain frequency characteristics of the high-pass filters HP51 and HP61 may be the same as each other. The cutoff frequencies of the high-pass filters HP51 and HP61 may be the same as each other.

The low-pass filter LP51 performs low-pass filter processing on the power supply voltage transmitted by the power line 56 (specifically, the positive power supply voltage and the negative power supply voltage output by the power supply unit 11). The power supply voltage subjected to the low-pass filter processing in the low-pass filter LP51 is transmitted to the load-side system 20 via the cable 60. The order of the low-pass filter LP51 is third order, for example.

The low-pass filter LP51 includes inductors L51 and L52 and a capacitor C51, for example. The inductors L51 and L52 are connected to each other in series, and are inserted into the power line 56. One end of the inductor L51 is connected to the power supply unit 11, and the other end of the inductor L51 is connected to one end of the inductor L52. The other end of the inductor L52 is connected to the other end of the capacitor C53 of the coupler CP51 and the cable 60. One end of the capacitor C51 is connected to the other end of the inductor L51 and the one end of the inductor L52. The other end of the capacitor C51 is connected to the ground. The power supply voltage output by the power supply unit 11 is input to the one end of the inductor L51.

The low-pass filter LP61 performs low-pass filter processing on the power supply voltage transmitted by the power line 56 (specifically, the positive power supply voltage and the negative power supply voltage transmitted to the load-side system 20 via the cable 60). The power supply voltage subjected to the low-pass filter processing in the low-pass filter LP61 is supplied to the one electrode of the brushed motor. The order of the low-pass filter LP61 is third order, for example.

The low-pass filter LP61 includes inductors L61 and L62 and a capacitor C61, for example. The inductors L61 and L62 are connected to each other in series, and are inserted into the power line 56. One end of the inductor L61 is connected to the one electrode of the brushed motor, and the other end of the inductor L61 is connected to one end of the inductor L62. The other end of the inductor L62 is connected to the other end of the capacitor C63 of the coupler CP61 and the cable 60. One end of the capacitor C61 is connected to the other end of the inductor L61 and the one end of the inductor L62. The other end of the capacitor C61 is connected to the ground. The power supply voltage transmitted to the load-side system 20 by the cable 60 is input to the other end of the inductor L62.

As described above, in the power supply-side interface circuit 14 of the processing system 1C, the low-pass filter LP51 performs the low-pass filter processing on the power supply voltage of a square wave, and thus the harmonic component included in the power supply voltage is attenuated. Accordingly, high-frequency noise due to the power supply voltage is less easily transmitted to the power supply-side communication unit 13 and the load-side system 20.

Even if high-frequency noise is generated in at least one of the power supply-side communication unit 13 and the load-side system 20, the high-frequency noise is less easily transmitted to the power supply unit 11 owing to the low-pass filter LP51.

In the present example, the coupler CP51 functions as the high-pass filter HP51, and thus even if low-frequency noise is generated in the power supply-side communication unit 13, the low-frequency noise is less easily superimposed on the power line 56. Accordingly, the low-frequency noise is less easily transmitted to the power supply unit 11 and the load-side system 20. Even if low-frequency noise is generated in at least one of the power supply unit 11 and the load-side system 20, the low-frequency noise is less easily transmitted to the power supply-side communication unit 13.

In the present example, the low-pass filter LP51 inserted into the power line 56 includes the inductors L51 and L52 at its both ends. The inductor L52 on the coupler CP51 side functions as an impedance increaser for the power supply-side single-ended signal to be superimposed on the power line 56 by the coupler CP51, and thus the power supply-side single-ended signal superimposed on the power line 56 is less easily transmitted toward the power supply unit 11. Accordingly, the signal level of the power supply-side single-ended signal input to the load-side communication unit 23 via the power line 56 is less easily reduced. The inductor L52 functions as an impedance increaser for the load-side single-ended signal to be superimposed on the power line 56 by the coupler CP61, and thus the load-side single-ended signal superimposed on the power line 56 is less easily transmitted toward the power supply unit 11. Accordingly, the signal level of the load-side single-ended signal input to the power supply-side communication unit 13 via the power line 56 is less easily reduced. On the other hand, the inductor L51 is present on the power supply unit 11 side, and thus even if output impedance of the power supply unit 11 is low, the low-pass filter LP51 can appropriately attenuate the harmonic component included in the power supply voltage output from the power supply unit 11.

In the load-side interface circuit 24, the low-pass filter LP61 performs the low-pass filter processing on the power supply voltage of a square wave, and thus the harmonic component included in the power supply voltage is attenuated. Accordingly, high-frequency noise due to the power supply voltage is less easily transmitted to the load 21.

Even if high-frequency noise is generated in at least one of the load-side communication unit 23 and the power supply-side communication unit 13, the high-frequency noise is less easily transmitted to the load 21 owing to the low-pass filter LP61.

Even if high-frequency noise is generated in the load 21, the high-frequency noise is less easily transmitted to the load-side communication unit 23 and the power supply-side system 10 owing to the low-pass filter LP61.

In the present example, the coupler CP61 functions as the high-pass filter HP61, and thus even if low-frequency noise is generated in the load-side communication unit 23, the low-frequency noise is less easily superimposed on the power line 56. Accordingly, the low-frequency noise is less easily transmitted to the load 21 and the power supply-side system 10. Even if low-frequency noise is generated in at least one of the load 21 and the power supply-side system 10, the low-frequency noise is less easily transmitted to the load-side communication unit 23.

In the present example, the low-pass filter LP61 inserted into the power line 56 includes the inductors L61 and L62 at its both ends. The inductor L62 on the coupler CP61 side functions as an impedance increaser for the load-side single-ended signal to be superimposed on the power line 56 by the coupler CP61, and thus the load-side single-ended signal superimposed on the power line 56 is less easily transmitted toward the load 21. Accordingly, the signal level of the load-side single-ended signal input to the power supply-side communication unit 13 via the power line 56 is less easily reduced. The inductor L62 functions as an impedance increaser for the power supply-side single-ended signal to be superimposed on the power line 56 by the coupler CP51, and thus the power supply-side single-ended signal superimposed on the power line 56 is less easily transmitted toward the load 21. Accordingly, the signal level of the power supply-side single-ended signal input to the load-side communication unit 23 via the power line 56 is less easily reduced. On the other hand, the inductor L61 is present on the load 21 side, and thus even if impedance seen from the side of the low-pass filter LP61 of the load 21 is low, the low-pass filter LP61 can appropriately attenuate the high-frequency noise output from the load 21.

The gain frequency characteristics of the low-pass filters LP51 and LP61 may be the same as each other. The cutoff frequencies of the low-pass filters LP51 and LP61 may be the same as each other.

In the processing system 1C, the lower limit value of a frequency band (also referred to as a second communication frequency band) of the power supply-side single-ended signal and the load-side single-ended signal is set higher than the frequency (for example, several kHz) of the fundamental wave component included in the power supply voltage of a square wave output by the power supply unit 11. The lower limit value of the second communication frequency band may be set 1000 times as high as or higher than the frequency of the fundamental wave component included in the power supply voltage, may be set 5000 times as high as or higher than the frequency, may be set 10000 times as high as or higher than the frequency, or may be set 50000 times as high as or higher than the frequency, for example.

A cutoff frequency (also referred to as a third LPF cutoff frequency) of the low-pass filters LP51 and LP61 is set to the frequency or higher of the fundamental wave component included in the power supply voltage, for example. A relationship between the third LPF cutoff frequency and the cutoff frequency (also referred to as a third HPF cutoff frequency) of the high-pass filters HP51 and HP61 may be the same as the above-described relationship between the LPF cutoff frequency fc1 and the HPF cutoff frequency fc2. A relationship between the third LPF cutoff frequency and the lower limit value of the second communication frequency band may be the same as the above-described relationship between the LPF cutoff frequency fc1 and the lower limit value fmin of the communication frequency band FB. A relationship between the third HPF cutoff frequency and the lower limit value of the second communication frequency band may be the same as the above-described relationship (for example, FIG. 4 or FIG. 5) between the HPF cutoff frequency fc2 and the lower limit value fmin of the communication frequency band FB.

Note that the order of the low-pass filters LP51 and LP61 may be odd order of fifth order or higher, or may be even order. The gain frequency characteristics of the low-pass filters LP51 and LP61 may be different from each other. The cutoff frequencies of the low-pass filters LP51 and LP61 may be different from each other. The orders of the low-pass filters LP51 and LP61 may be different from each other.

The gain frequency characteristics of the high-pass filters HP51 and HP61 may be different from each other. The cutoff frequencies of the high-pass filters HP51 and HP61 may be different from each other. The orders of the high-pass filters HP51 and HP61 may be different from each other.

The constant of the inductor L52 of the power supply-side interface circuit 14 and the constant of the inductor L62 of the load-side interface circuit 24 may be different from each other. The constant of the inductor L52 may be set larger than the constant of the inductor L62, and the constant of the inductor L62 may be set larger than the constant of the inductor L52.

In the load-side interface circuit 24, the low-pass filter LP61 need not be provided. In the power supply-side interface circuit 14, the low-pass filter LP51 need not be provided.

In the processing system 1C, the coupler CP51 may include an isolation transformer. In this case, one end of a primary-side coil of the isolation transformer is connected the communication unit 13 and one end of the resistor R51 and the other end of the primary-side coil is connected to the ground, and one end of a secondary-side coil of the isolation transformer is connected to one end of the capacitor C53 and the other end of the secondary-side coil is connected to the ground.

The coupler CP61 may include an isolation transformer. In this case, one end of a primary-side coil of the isolation transformer is connected the communication unit 23 and one end of the resistor R61 and the other end of the primary-side coil is connected to the ground, and one end of a secondary-side coil of the isolation transformer is connected to one end of the capacitor C63 and the other end of the secondary-side coil is connected to the ground.

The power supply unit 11 may output only the positive power supply voltage out of the positive power supply voltage and the negative power supply voltage, or may output only the negative power supply voltage out of the positive power supply voltage and the negative power supply voltage. In this case, the brushed motor can rotate in one direction only.

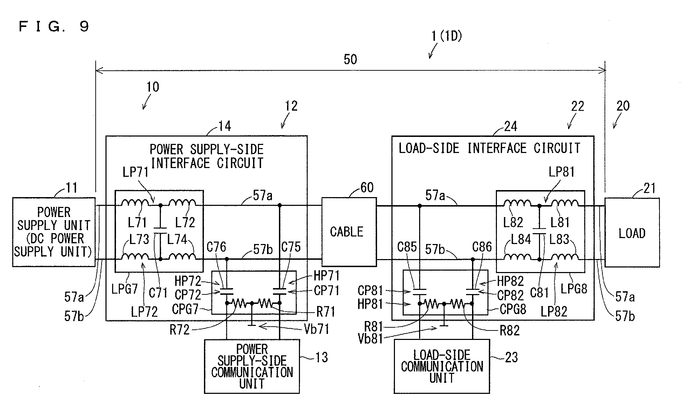

FIG. 9 is a schematic diagram illustrating an example of the processing system 1 when the power supply unit 11 is a DC power supply unit that outputs a DC power supply voltage to be supplied to the load 21. In the processing system 1 (also referred to as a processing system 1D) illustrated in FIG. 9, the power line 50 includes a first power line 57a and a second power line 57b. The first power line 57a transmits the DC power supply voltage output by the power supply unit 11. The second power line 57b is connected to the ground of the power supply unit 11. It can also be said that the second power line 57b is a ground line, for example. The power supply unit 11 outputs a positive DC power supply voltage, for example. The DC power supply voltage output by the power supply unit 11 may be of several volts.

The load 21 may be a brushed motor that operates on a low voltage, or may be another device that operates on the DC power supply voltage. When the load 21 is a brushed motor, the first power line 57a may be connected to the one electrode of the brushed motor, and the second power line 57b may be connected to the other electrode of the brushed motor. In this case, the DC power supply voltage is supplied to the brushed motor.

The power supply-side interface circuit 14 included in the processing system 1D includes a low-pass filter unit LPG7 including low-pass filters LP71 and LP72 and a coupler unit CPG7, for example. The load-side interface circuit 24 included in the processing system 1D includes a low-pass filter unit LPG8 including low-pass filters LP81 and LP82 and a coupler unit CPG8, for example.

The coupler unit CPG7 includes couplers CP71 and CP72. The coupler CP71 superimposes one power supply-side communication signal of the power supply-side differential signal transmitted by the communication unit 13 on the first power line 57a. The coupler CP72 superimposes the other power supply-side communication signal of the power supply-side differential signal transmitted by the communication unit 13 on the second power line 57b.

The coupler unit CPG8 includes couplers CP81 and CP82. The coupler CP81 superimposes one power supply-side communication signal of the power supply-side differential signal transmitted by the communication unit 23 on the first power line 57a. The coupler CP82 superimposes the other power supply-side communication signal of the power supply-side differential signal transmitted by the communication unit 23 on the second power line 57b.

The coupler CP71 extracts one load-side communication signal from the first power line 57a on which the one load-side communication signal is superimposed, and outputs the one load-side communication signal to the communication unit 13. The coupler CP72 extracts the other load-side communication signal from the second power line 57b on which the other load-side communication signal is superimposed, and outputs the other load-side communication signal to the communication unit 13.

The coupler CP81 extracts one power supply-side communication signal from the first power line 57a on which the one power supply-side communication signal is superimposed, and outputs the one power supply-side communication signal to the communication unit 23. The coupler CP82 extracts the other power supply-side communication signal from the second power line 57b on which the other power supply-side communication signal is superimposed, and outputs the other power supply-side communication signal to the communication unit 23.

The coupler CP71 includes a capacitor C75 and a resistor R71, for example. One end of the capacitor C75 is connected to the communication unit 13 and one end of the resistor R71, and the other end of the capacitor C75 is connected to the first power line 57a. The coupler CP72 includes a capacitor C76 and a resistor R72, for example. One end of the capacitor C76 is connected to the communication unit 13 and one end of the resistor R72, and the other end of the capacitor C76 is connected to the second power line 57b. The other end of the resistor R72 is connected to the other end of the resistor R71. A bias voltage Vb71 is applied to the other end of the resistor R72 and the other end of the resistor R71.

The coupler CP81 includes a capacitor C85 and a resistor R81, for example. One end of the capacitor C85 is connected to the communication unit 23 and one end of the resistor R81, and the other end of the capacitor C85 is connected to the first power line 57a. The coupler CP82 includes a capacitor C86 and a resistor R82, for example. One end of the capacitor C86 is connected to the communication unit 23 and one end of the resistor R82, and the other end of the capacitor C86 is connected to the second power line 57b. The other end of the resistor R82 is connected to the other end of the resistor R81. A bias voltage Vb81 is applied to the other end of the resistor R82 and the other end of the resistor R81.

The coupler CP71 constitutes a high-pass filter HP71. In other words, the capacitor C75 and the resistor R71 constitute the high-pass filter HP71. The high-pass filter HP71 performs high-pass filter processing on one power supply-side communication signal transmitted by the communication unit 13. On the first power line 57a, the one power supply-side communication signal subjected to the high-pass filter processing in the high-pass filter HP71 is superimposed. The high-pass filter HP71 performs high-pass filter processing on one load-side communication signal extracted from the first power line 57a. The one load-side communication signal subjected to the high-pass filter processing in the high-pass filter HP71 is received in the communication unit 13.

The coupler CP72 constitutes a high-pass filter HP72. The high-pass filter HP72 performs high-pass filter processing on the other power supply-side communication signal transmitted by the communication unit 13. On the second power line 57b, the other power supply-side communication signal subjected to the high-pass filter processing in the high-pass filter HP72 is superimposed. The high-pass filter HP72 performs high-pass filter processing on the other load-side communication signal extracted from the second power line 57b. The other load-side communication signal subjected to the high-pass filter processing in the high-pass filter HP72 is received in the communication unit 13.

The coupler CP81 constitutes a high-pass filter HP81. The high-pass filter HP81 performs high-pass filter processing on one load-side communication signal transmitted by the communication unit 23. On the first power line 57a, the one load-side communication signal subjected to the high-pass filter processing in the high-pass filter HP81 is superimposed. The high-pass filter HP81 performs high-pass filter processing on one power supply-side communication signal extracted from the first power line 57a. The one power supply-side communication signal subjected to the high-pass filter processing in the high-pass filter HP81 is received in the communication unit 23.

The coupler CP82 constitutes a high-pass filter HP82. The high-pass filter HP82 performs high-pass filter processing on the other load-side communication signal transmitted by the communication unit 23. On the second power line 57b, the other load-side communication signal subjected to the high-pass filter processing in the high-pass filter HP82 is superimposed. The high-pass filter HP82 performs high-pass filter processing on the other power supply-side communication signal extracted from the second power line 57b. The other power supply-side communication signal subjected to the high-pass filter processing in the high-pass filter HP82 is received in the communication unit 23.

The order of the high-pass filters HP71, HP72, HP81, and HP82 is second order, for example. The gain frequency characteristics of the high-pass filters HP71, HP72, HP81, and HP82 may be the same as each other. The cutoff frequencies of the high-pass filters HP71, HP72, HP81, and HP82 may be the same as each other.

The low-pass filter unit LPG7 includes inductors L71, L72, L73, and L74 and a capacitor C71, for example. The inductors L71 and L72 are connected to each other in series, and are inserted into the first power line 57a. One end of the inductor L71 is connected to the power supply unit 11, and the other end of the inductor L71 is connected to one end of the inductor L72. The other end of the inductor L72 is connected to the other end of the capacitor C75 of the coupler CP71 and the cable 60. The DC power supply voltage output by the power supply unit 11 is input to the one end of the inductor L71.

The inductors L73 and L74 are connected to each other in series, and are inserted into the second power line 57b. One end of the inductor L73 is connected to the power supply unit 11, and the other end of the inductor L73 is connected to one end of the inductor L74. The other end of the inductor L74 is connected to the other end of the capacitor C76 of the coupler CP72 and the cable 60. The one end of the inductor L73 is connected to the ground of the power supply unit 11.

One end of the capacitor C71 is connected to the other end of the inductor L71 and the one end of the inductor L72. The other end of the capacitor C71 is connected to the other end of the inductor L73 and the one end of the inductor L74.

In the low-pass filter unit LPG7, the inductors L71 and L72 and the capacitor C71 constitute the low-pass filter LP71. The low-pass filter LP71 is inserted into the first power line 57a. In the low-pass filter unit LPG7, the inductors L73 and L74 and the capacitor C71 constitute the low-pass filter LP72. The low-pass filter LP72 is inserted into the second power line 57b. The order of the low-pass filters LP71 and LP72 is third order, for example.

In the low-pass filter unit LPG8, inductors L81 and L82 and a capacitor C81 constitute the low-pass filter LP81. The low-pass filter LP81 is inserted into the first power line 57a. In the low-pass filter unit LPG8, inductors L83 and L84 and the capacitor C81 constitute the low-pass filter LP82. The low-pass filter LP82 is inserted into the second power line 57b. The order of the low-pass filters LP81 and LP82 is third order, for example.

The DC power supply voltage output by the power supply unit 11 is supplied to the load 21 via the low-pass filter LP71 and the low-pass filter LP81.

As described above, in the power supply-side interface circuit 14 of the processing system 1D, the low-pass filters LP71 and LP72 are inserted into the first power line 57a and the second power line 57b connected to the power supply unit 11. Thus, even if high-frequency noise is generated in the power supply unit 11, the high-frequency noise is less easily transmitted to the power supply-side communication unit 13 and the load-side system 20.

Even if high-frequency noise is generated in at least one of the power supply-side communication unit 13 and the load-side system 20, the high-frequency noise is less easily transmitted to the power supply unit 11 owing to the low-pass filter unit LPG7.

In the present example, the couplers CP71 and CP72 respectively function as the high-pass filters HP71 and HP72, and thus even if low-frequency noise is generated in the power supply-side communication unit 13, the low-frequency noise is less easily superimposed on the first power line 57a and the second power line 57b. Accordingly, the low-frequency noise is less easily transmitted to the power supply unit 11 and the load-side system 20. Even if low-frequency noise is generated in at least one of the power supply unit 11 and the load-side system 20, the low-frequency noise is less easily transmitted to the power supply-side communication unit 13.

In the present example, the low-pass filter LP71 inserted into the first power line 57a includes the inductors L71 and L72 at its both ends. The inductor L72 on the coupler CP71 side functions as an impedance increaser for the power supply-side communication signal to be superimposed on the first power line 57a by the coupler CP71, and thus the power supply-side communication signal superimposed on the first power line 57a is less easily transmitted toward the power supply unit 11. Accordingly, the signal level of the power supply-side communication signal input to the load-side communication unit 23 via the first power line 57a is less easily reduced. The inductor L72 functions as an impedance increaser for the load-side communication signal to be superimposed on the first power line 57a by the coupler CP81, and thus the load-side communication signal superimposed on the first power line 57a is less easily transmitted toward the power supply unit 11. Accordingly, the signal level of the load-side communication signal input to the power supply-side communication unit 13 via the first power line 57a is less easily reduced. On the other hand, the inductor L71 is present on the power supply unit 11 side, and thus even if output impedance of the power supply unit 11 is low, the low-pass filter LP71 can appropriately attenuate the high-frequency noise generated in the power supply unit 11. It can be said that the same applies to the low-pass filter LP72 inserted into the second power line 57b.

In the load-side interface circuit 24, the low-pass filters LP81 and LP82 are inserted into the first power line 57a and the second power line 57b connected to the power supply unit 11. Thus, even if high-frequency noise is generated in the power supply unit 11, the high-frequency noise is less easily transmitted to the load 21.

Even if high-frequency noise is generated in at least one of the load-side communication unit 23 and the power supply-side communication unit 13, the high-frequency noise is less easily transmitted to the load 21 owing to the low-pass filters LP81 and LP82. Even if high-frequency noise is generated in the load 21, the high-frequency noise is less easily transmitted to the load-side communication unit 23 and the power supply-side system 10 owing to the low-pass filter unit LPG8.

In the present example, the couplers CP81 and CP82 respectively function as the high-pass filters HP81 and HP82, and thus even if low-frequency noise is generated in the load-side communication unit 23, the low-frequency noise is less easily superimposed on the first power line 57a and the second power line 57b. Accordingly, the low-frequency noise is less easily transmitted to the load 21 and the power supply-side system 10. Even if low-frequency noise is generated in at least one of the load 21 and the power supply-side system 10, the low-frequency noise is less easily transmitted to the load-side communication unit 23.

In the present example, the low-pass filter LP81 inserted into the first power line 57a includes the inductors L81 and L82 at its both ends. The inductor L82 on the coupler CP81 side functions as an impedance increaser for the load-side communication signal to be superimposed on the first power line 57a by the coupler CP81, and thus the load-side communication signal superimposed on the first power line 57a is less easily transmitted toward the load 21. Accordingly, the signal level of the load-side communication signal input to the power supply-side communication unit 13 via the first power line 57a is less easily reduced. The inductor L82 functions as an impedance increaser for the power supply-side communication signal to be superimposed on the first power line 57a by the coupler CP71, and thus the power supply-side communication signal superimposed on the first power line 57a is less easily transmitted toward the load 21. Accordingly, the signal level of the power supply-side communication signal input to the load-side communication unit 23 via the first power line 57a is less easily reduced. On the other hand, the inductor L81 is present on the load 21 side, and thus even if impedance seen from the side of the low-pass filter LP81 of the load 21 is low, the low-pass filter LP81 can appropriately attenuate the high-frequency noise output from the load 21. It can be said that the same applies to the low-pass filter LP82 inserted into the second power line 57b.

The gain frequency characteristics of the low-pass filters LP71, LP72, LP81, and LP82 may be the same as each other. The cutoff frequencies of the low-pass filters LP71, LP72, LP81, and LP82 may be the same as each other. A relationship between the cutoff frequency of the low-pass filters LP71, LP72, LP81, and LP82 and the lower limit value fmin of the communication frequency band FB may be the same as the above-described relationship between the LPF cutoff frequency fc1 and the lower limit value fmin of the communication frequency band FB.

A relationship between the cutoff frequency of the low-pass filters LP71, LP72, LP81, and LP82 and the cutoff frequency of the high-pass filters HP71, HP72, HP81, and HP82 may be the same as the above-described relationship between the LPF cutoff frequency fc1 and the HPF cutoff frequency fc2. A relationship between the cutoff frequency of the high-pass filters HP71, HP72, HP81, and HP82 and the lower limit value fmin of the communication frequency band FB may be the same as the above-described relationship between the HPF cutoff frequency fc2 and the lower limit value fmin of the communication frequency band FB.

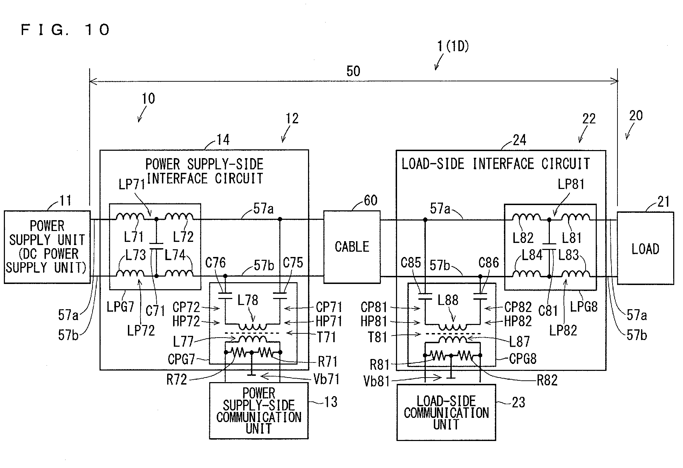

In the processing system 1D, as illustrated in FIG. 10, the coupler CP71 may include an isolation transformer T71. In this case, one end of a primary-side coil L77 of the isolation transformer T71 is connected to the communication unit 13 and one end of the resistor R71. The other end of the primary-side coil L77 is connected to the communication unit 13 and one end of the resistor R72. One end and the other end of a secondary-side coil L78 of the isolation transformer T71 are respectively connected to one end of the capacitor C75 and one end of the capacitor C76. In the example of FIG. 10, the capacitor C75, the isolation transformer T71, and the resistor R71 constitute the high-pass filter HP71. The capacitor C76, the isolation transformer T71, and the resistor R72 constitute the high-pass filter HP72.

As illustrated in FIG. 10, the coupler CP81 may include an isolation transformer T81. In this case, one end of a primary-side coil L87 of the isolation transformer T81 is connected to the communication unit 23 and one end of the resistor R81. The other end of the primary-side coil L87 is connected to the communication unit 23 and one end of the resistor R82. One end and the other end of a secondary-side coil L88 of the isolation transformer T81 are respectively connected to one end of the capacitor C85 and one end of the capacitor C86. In the example of FIG. 10, the capacitor C85, the isolation transformer T81, and the resistor R81 constitute the high-pass filter HP81. The capacitor C86, the isolation transformer T81, and the resistor R82 constitute the high-pass filter HP82.

Note that the order of the low-pass filters LP71, LP72, LP81, and LP82 may be odd order of fifth order or higher, or may be even order. The gain frequency characteristics of at least two low-pass filters of the low-pass filters LP71, LP72, LP81, and LP82 may be different from each other. The cutoff frequencies of at least two low-pass filters of the low-pass filters LP71, LP72, LP81, and LP82 may be different from each other. The orders of at least two low-pass filters of the low-pass filters LP71, LP72, LP81, and LP82 may be different from each other.

The gain frequency characteristics of at least two high-pass filters of the high-pass filters HP71, HP72, HP81, and HP82 may be different from each other. The cutoff frequencies of at least two high-pass filters of the high-pass filters HP71, HP72, HP81, and HP82 may be different from each other. The orders of at least two high-pass filters of the high-pass filters HP71, HP72, HP81, and HP82 may be different from each other.

The constant of the inductor L72 of the power supply-side interface circuit 14 and the constant of the inductor L82 of the load-side interface circuit 24 may be different from each other. The constant of the inductor L72 may be set larger than the constant of the inductor L82, and the constant of the inductor L82 may be set larger than the constant of the inductor L72. Similarly, the constant of the inductor L74 of the power supply-side interface circuit 14 and the constant of the inductor L84 of the load-side interface circuit 24 may be different from each other.

In the load-side interface circuit 24, the low-pass filter unit LPG8 need not be provided. In the power supply-side interface circuit 14, the low-pass filter unit LPG7 need not be provided.

The power supply-side communication unit 13 and the load-side communication unit 23 may perform single-ended communication. In this case, the power supply-side single-ended signal output by the power supply-side communication unit 13 is superimposed on one of the first power line 57a and the second power line 57b. The load-side single-ended signal output by the load-side communication unit 23 is superimposed on one of the first power line 57a and the second power line 57b. In the example of FIG. 9, when the power supply-side single-ended signal is superimposed on the first power line 57a, for example, in the coupler unit CPG7, the capacitor C76 and the resistor R72 are unnecessary. In the example of FIG. 9, when the load-side single-ended signal is superimposed on the first power line 57a, for example, in the coupler unit CPG8, the capacitor C86 and the resistor R82 are unnecessary. In the example of FIG. 10, when the power supply-side single-ended signal is superimposed on the first power line 57a, for example, in the coupler unit CPG7, the capacitor C76 and the resistor R72 are unnecessary, and one end of the primary-side coil L77 and one end of the secondary-side coil L78 are connected to the ground. In the example of FIG. 10, when the load-side single-ended signal is superimposed on the first power line 57a, for example, in the coupler unit CPG8, the capacitor C86 and the resistor R82 are unnecessary, and one end of the primary-side coil L87 and one end of the secondary-side coil L88 are connected to the ground.

The low-pass filter unit LPG7 need not include the inductors L71 and L73. For example, when an AC component does not flow through the first power line 57a and the second power line 57b, or when the AC component, even if the AC component flows through the first power line 57a and the second power line 57b, is minute or the like, the low-pass filter unit LPG7 need not include the inductors L71 and L73.

The low-pass filter unit LPG8 need not include the inductors L81 and L83. For example, when an AC component does not flow through the first power line 57a and the second power line 57b, or when the AC component, even if the AC component flows through the first power line 57a and the second power line 57b, is minute or the like, the low-pass filter unit LPG8 need not include the inductors L81 and L83.

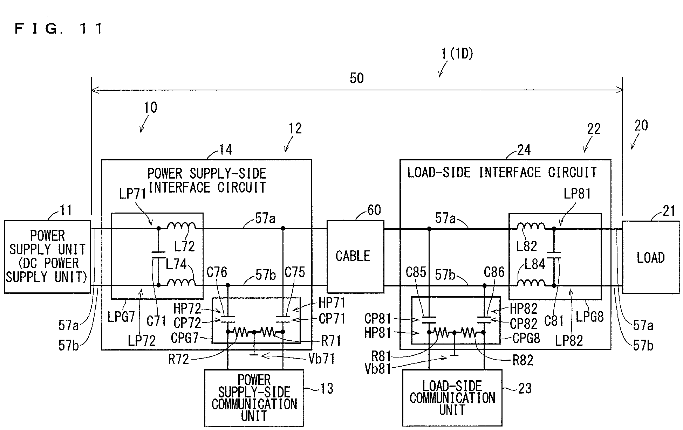

FIG. 11 is a schematic diagram illustrating a state in which the low-pass filter unit LPG7 does not include the inductors L71 and L73 and the low-pass filter unit LPG8 does not include the inductors L81 and L83 in the configuration illustrated in FIG. 9. Note that, in the configuration illustrated in FIG. 10, the low-pass filter unit LPG7 need not include the inductors L71 and L73. In the configuration illustrated in FIG. 10, the low-pass filter unit LPG8 need not include the inductors L81 and L83.

The functionality of the elements disclosed herein may be implemented using circuitry or processing circuitry which includes general purpose processors, special purpose processors, integrated circuits, ASICs ("Application Specific Integrated Circuits"), conventional circuitry and/or combinations thereof which are configured or programmed to perform the disclosed functionality. Processors are considered processing circuitry or circuitry as they include transistors and other circuitry therein. In the disclosure, the circuitry, units, or means are hardware that carry out or are programmed to perform the recited functionality. The hardware may be any hardware disclosed herein or otherwise known which is programmed or configured to carry out the recited functionality. When the hardware is a processor which may be considered a type of circuitry, the circuitry, means, or units are a combination of hardware and software, the software being used to configure the hardware and/or processor.

As described above, while the processing system has been described in detail, the foregoing description is in all aspects illustrative, and the present disclosure is not limited thereto. Various modifications described above can be applied in combination, on the condition that the combination is consistent. It is therefore understood that numerous unillustrated modifications can be devised without departing from the scope of the present disclosure.

The present disclosure includes the following aspects.

An interface circuit according to a first aspect includes: a first coupler configured to superimpose a first communication signal on a first power line transmitting a first power supply voltage of a square wave, or extract a first communication signal from a first power line transmitting a first power supply voltage of a square wave on which the first communication signal is superimposed; and a first low-pass filter inserted into the first power line and connected to the first coupler. The first low-pass filter includes a first inductor at each of both ends of the first low-pass filter.

An interface circuit according to a second aspect is the interface circuit according to the first aspect. A cutoff frequency of the first low-pass filter is a lower limit value or less of a frequency band of the first communication signal.

An interface circuit according to a third aspect is the interface circuit according to the second aspect. The cutoff frequency of the first low-pass filter is one-third or less of the lower limit value.

An interface circuit according to a fourth aspect is the interface circuit according to the second or third aspect. The first coupler includes a high-pass filter. The cutoff frequency of the high-pass filter is the lower limit value or less. The cutoff frequency of the first low-pass filter is lower than the cutoff frequency of the high-pass filter.

An interface circuit according to a fifth aspect is the interface circuit according to the fourth aspect. A difference between the cutoff frequency of the high-pass filter and the cutoff frequency of the first low-pass filter is a half or more of a frequency bandwidth of the first communication signal.

An interface circuit according to a sixth aspect is the interface circuit according to any one of the first to fifth aspects. The first coupler includes a high-pass filter. Order of the first low-pass filter is higher than the order of the high-pass filter.

An interface circuit according to a seventh aspect is the interface circuit according to any one of the first to sixth aspects. Order of the first low-pass filter is odd order.

An interface circuit according to an eighth aspect is the interface circuit according to any one of the first to seventh aspects. The interface circuit further includes: a second coupler configured to superimpose a second communication signal constituting a differential signal in conjunction with the first communication signal on a second power line transmitting a second power supply voltage of a square wave, or extract a second communication signal from a second power line transmitting the second power supply voltage of a square wave on which the second communication signal constituting a differential signal in conjunction with the first communication signal is superimposed; and a second low-pass filter inserted into the second power line and connected to the second coupler. The second low-pass filter includes a second inductor at each of both ends of the second low-pass filter.

A communication apparatus according to a ninth aspect includes: the interface circuit according to any one of the first to eighth aspects; and a communication unit configured to transmit the first communication signal to the first coupler. The first coupler superimposes the first communication signal transmitted from the communication unit on the first power line.

A communication apparatus according to a tenth aspect includes: the interface circuit according to any one of the first to eighth aspects; and a communication unit configured to receive the first communication signal extracted by the first coupler from the first power line on which the first communication signal is superimposed.

An interface system according to an eleventh aspect includes: a first interface circuit being the interface circuit according to any one of the first to eighth aspects; and a second interface circuit connected to the first interface circuit via the first power line. The first coupler superimposes the first communication signal on the first power line, and is connected to the first inductor of the first low-pass filter on a side of the second interface circuit. The second interface circuit includes a third coupler configured to extract the first communication signal from the first power line on which the first communication signal is superimposed, and a third low-pass filter inserted into the first power line and connected to the third coupler. The third low-pass filter includes a third inductor at each of both ends of the third low-pass filter. The third coupler is connected to the third inductor of the third low-pass filter on a side of the first interface circuit.

An interface system according to a twelfth aspect is the interface system according to the eleventh aspect. A constant of the first inductor of the first low-pass filter on the side of the second interface circuit and a constant of the third inductor of the third low-pass filter on the side of the first interface circuit are different from each other.

An interface system according to a thirteenth aspect is the interface system according to the eleventh or twelfth aspect. The third coupler superimposes a third communication signal on the first power line. The first coupler extracts the third communication signal from the first power line on which the third communication signal is superimposed.

An interface system according to a fourteenth aspect is the interface system according to any one of the eleventh to thirteenth aspects. The first power supply voltage of the square wave is input to the first inductor of the first low-pass filter on a side opposite to the side of the second interface circuit. The first power line transmits the first power supply voltage output from the first low-pass filter to the second interface circuit. The first power supply voltage transmitted by the first power line is input to the third inductor of the third low-pass filter on the side of the first interface circuit. The third inductor of the third low-pass filter on a side opposite to the side of the first interface circuit is connected to a load.

An interface system according to a fifteenth aspect is the interface system according to any one of the eleventh to thirteenth aspects. The first power supply voltage of the square wave is input to the third inductor of the third low-pass filter on a side opposite to the side of the first interface circuit. The first power line transmits the first power supply voltage output from the third low-pass filter to the first interface circuit. The first power supply voltage transmitted by the first power line is input to the first inductor of the first low-pass filter on the side of the second interface circuit. The first inductor of the first low-pass filter on a side opposite to the side of the second interface circuit is connected to a load.

A communication system according to a sixteenth aspect includes: the interface system according to any one of the eleventh to fifteenth aspects; a first communication unit configured to transmit the first communication signal to the first coupler; and a second communication unit configured to receive the first communication signal extracted by the third coupler from the first power line on which the first communication signal is superimposed.

An interface circuit according to a seventeenth aspect includes: a coupler configured to superimpose a communication signal on a power line transmitting a DC power supply voltage, or extract a communication signal from a power line transmitting a DC power supply voltage on which the communication signal is superimposed; and a low-pass filter inserted into the power line and electrically connected to the coupler. The low-pass filter includes an inductor located at one end of the low-pass filter and electrically connected to the coupler.

## Claims

1. An interface circuit (14, 24) comprising:
a first coupler (CP11, CP12, CP21, CP22, CP51, CP61) configured to superimpose a first communication signal on a first power line (51, 52, 55a, 55b, 56) transmitting a first power supply voltage of a square wave, or extract a first communication signal from a first power line transmitting a first power supply voltage of a square wave on which the first communication signal is superimposed; and
a first low-pass filter (LP11, LP12, LP21, LP22, LP31, LP32, LP41, LP42, LP51, LP61) inserted into the first power line (51, 52, 55a, 55b, 56) and connected to the first coupler (CP11, CP12, CP21, CP22, CP51, CP61), wherein
the first low-pass filter (LP11, LP12, LP21, LP22, LP31, LP32, LP41, LP42, LP51, LP61) includes a first inductor (L11, L12, L13, L14, L21, L22, L23, L24, L31, L32, L33, L34, L41, L42, L43, L44, L51, L52, L61, L62) at each of both ends of the first low-pass filter (LP11, LP12, LP21, LP22, LP31, LP32, LP41, LP42, LP51, LP61).

2. The interface circuit (14, 24) according to claim 1, wherein
a cutoff frequency of the first low-pass filter (LP11, LP12, LP21, LP22, LP31, LP32, LP41, LP42, LP51, LP61) is a lower limit value or less of a frequency band of the first communication signal.

3. The interface circuit (14, 24) according to claim 2, wherein
the cutoff frequency of the first low-pass filter (LP11, LP12, LP21, LP22, LP31, LP32, LP41, LP42, LP51, LP61) is one-third or less of the lower limit value.

4. The interface circuit (14, 24) according to claim 2 or 3, wherein
the first coupler (CP11, CP12, CP21, CP22, CP51, CP61) includes a high-pass filter (HP11, HP12, HP21, HP22, HP51, HP61),
a cutoff frequency of the high-pass filter (HP11, HP12, HP21, HP22, HP51, HP61) is the lower limit value or less, and
the cutoff frequency of the first low-pass filter (LP11, LP12, LP21, LP22, LP31, LP32, LP41, LP42, LP51, LP61) is lower than the cutoff frequency of the high-pass filter.

5. The interface circuit (14, 24) according to claim 4, wherein
a difference between the cutoff frequency of the high-pass filter (HP11, HP12, HP21, HP22, HP51, HP61) and the cutoff frequency of the first low-pass filter (LP11, LP12, LP21, LP22, LP31, LP32, LP41, LP42, LP51, LP61) is a half or more of a frequency bandwidth of the first communication signal.

6. The interface circuit (14, 24) according to any one of claims 1 to 5, wherein
the first coupler (CP11, CP12, CP21, CP22, CP51, CP61) includes a high-pass filter (HP11, HP12, HP21, HP22, HP51, HP61), and
order of the first low-pass filter (LP11, LP12, LP21, LP22, LP31, LP32, LP41, LP42, LP51, LP61) is higher than the order of the high-pass filter (HP11, HP12, HP21, HP22, HP51, HP61).

7. The interface circuit (14, 24) according to any one of claims 1 to 6, wherein
order of the first low-pass filter (LP11, LP12, LP21, LP22, LP31, LP32, LP41, LP42, LP51, LP61) is odd order.

8. The interface circuit (14, 24) according to any one of claims 1 to 7, further comprising:
a second coupler (CP11, CP12, CP21, CP22) configured to superimpose a second communication signal constituting a differential signal in conjunction with the first communication signal on a second power line (51, 52, 55a, 55b) transmitting a second power supply voltage of a square wave, or extract a second communication signal from a second power line (51, 52, 55a, 55b) transmitting a second power supply voltage of a square wave on which the second communication signal constituting a differential signal in conjunction with the first communication signal is superimposed; and
a second low-pass filter (LP11, LP12, LP21, LP22, LP31, LP32, LP41, LP42) inserted into the second power line (51, 52, 55a, 55b) and connected to the second coupler (CP11, CP12, CP21, CP22), wherein
the second low-pass filter (LP11, LP12, LP21, LP22, LP31, LP32, LP41, LP42) includes a second inductor (L11, L12, L13, L14, L21, L22, L23, L24, L31, L32, L33, L34, L41, L42, L43, L44) at each of both ends of the second low-pass filter (LP11, LP12, LP21, LP22, LP31, LP32, LP41, LP42).

9. A communication apparatus (12, 22) comprising:
the interface circuit (14, 24) according to any one of claims 1 to 8; and
a communication unit (13, 23) configured to transmit the first communication signal to the first coupler (CP11, CP12, CP21, CP22, CP51, CP61), wherein
the first coupler (CP11, CP12, CP21, CP22, CP51, CP61) superimposes the first communication signal transmitted from the communication unit on the first power line.

10. A communication apparatus (12, 22) comprising:
the interface circuit (14, 24) according to any one of claims 1 to 8; and
a communication unit (13, 23) configured to receive the first communication signal extracted by the first coupler (CP11, CP12, CP21, CP22, CP51, CP61) from the first power line on which the first communication signal is superimposed.

11. An interface system (34) comprising:
a first interface circuit (14, 24) being the interface circuit according to any one of claims 1 to 8; and
a second interface circuit (14, 24) connected to the first interface circuit (14, 24) via the first power line (51, 52, 55a, 55b, 56), wherein
the first coupler (CP11, CP12, CP21, CP22, CP51, CP61) superimposes the first communication signal on the first power line (51, 52, 55a, 55b, 56), and is connected to the first inductor (L12, L14, L22, L24, L32, L34, L42, L44, L52, L62) of the first low-pass filter (LP11, LP12, LP21, LP22, LP31, LP32, LP41, LP42, LP51, LP61) on a side of the second interface circuit (14, 24),
the second interface circuit (14, 24) includes
a third coupler (CP11, CP12, CP21, CP22, CP51, CP61) configured to extract the first communication signal from the first power line (51, 52, 55a, 55b, 56) on which the first communication signal is superimposed, and
a third low-pass filter (LP11, LP12, LP21, LP22, LP31, LP32, LP41, LP42, LP51, LP61) inserted into the first power line (51, 52, 55a, 55b, 56) and connected to the third coupler (CP11, CP12, CP21, CP22, CP51, CP61),
the third low-pass filter (LP11, LP12, LP21, LP22, LP31, LP32, LP41, LP42, LP51, LP61) includes a third inductor (L11, L12, L13, L14, L21, L22, L23, L24, L31, L32, L33, L34, L41, L42, L43, L44, L51, L52, L61, L62) at each of both ends of the third low-pass filter (LP11, LP12, LP21, LP22, LP31, LP32, LP41, LP42, LP51, LP61), and
the third coupler (CP11, CP12, CP21, CP22, CP51, CP61) is connected to the third inductor (L12, L14, L22, L24, L32, L34, L42, L44, L52, L62) of the third low-pass filter (LP11, LP12, LP21, LP22, LP31, LP32, LP41, LP42, LP51, LP61) on a side of the first interface circuit (14, 24).

12. The interface system (34) according to claim 11, wherein
a constant of the first inductor (L12, L14, L22, L24, L32, L34, L42, L44, L52, L62) of the first low-pass filter (LP11, LP12, LP21, LP22, LP31, LP32, LP41, LP42, LP51, LP61) on the side of the second interface circuit (14, 24) and a constant of the third inductor (L12, L14, L22, L24, L32, L34, L42, L44, L52, L62) of the third low-pass filter (LP11, LP12, LP21, LP22, LP31, LP32, LP41, LP42, LP51, LP61) on the side of the first interface circuit (14, 24) are different from each other.

13. The interface system (34) according to claim 11 or 12, wherein
the third coupler (CP11, CP12, CP21, CP22, CP51, CP61) superimposes a third communication signal on the first power line (51, 52, 55a, 55b, 56), and
the first coupler (CP11, CP12, CP21, CP22, CP51, CP61) extracts the third communication signal from the first power line (51, 52, 55a, 55b, 56) on which the third communication signal is superimposed.

14. A communication system (32) comprising:
the interface system (34) according to any one of claims 11 to 13;
a first communication unit (12, 22) configured to transmit the first communication signal to the first coupler (CP11, CP12, CP21, CP22, CP51, CP61); and
a second communication unit (12, 22) configured to receive the first communication signal extracted by the third coupler (CP11, CP12, CP21, CP22, CP51, CP61) from the first power line (51, 52, 55a, 55b, 56) on which the first communication signal is superimposed.

15. An interface circuit (14, 24) comprising:
a coupler (CP71, CP81) configured to superimpose a communication signal on a power line (57a) transmitting a DC power supply voltage, or extract a communication signal from a power line (57a) transmitting a DC power supply voltage on which the communication signal is superimposed; and
a low-pass filter (LP71, LP81) inserted into the power line (57a) and electrically connected to the coupler (CP71, CP81), wherein
the low-pass filter (LP71, LP81) includes an inductor (L72, L82) located at one end of the low-pass filter and electrically connected to the coupler (CP71, CP81).
